# EUROPEAN PATENT APPLICATION

(11) **EP 2 695 898 A1**
(43) Date of publication of application: **12.02.2014**
(21) Application number: 11863125.8
(22) Date of filing: 07.04.2011
(51) Int. Cl.: C08F 2/00, H01B 3/30, H01L 23/29, H01L 23/31, H02K 3/30

(54) **RESIN MATERIAL, METHOD FOR PRODUCING SAME, METHOD FOR REPAIRING SAME, AND MEMBERS USING SAME**

(71) Applicant: Hitachi, Ltd., Tokyo 100-8280 (JP)
(72) Inventor: NUNOSHIGE Jun, Hitachi-shi, Ibaraki 319-1292 (JP); MURAKI Takahito, Hitachi-shi Ibaraki 319-1292 (JP); AMO Satoru, Hitachi-shi Ibaraki 319-1292 (JP); KAGAWA Hiroyuki, Hitachi-shi Ibaraki 319-1292 (JP)
(74) Representative: Beetz & Partner
(86) International application number: PCT/JP2011/058831
(87) International publication number: WO 2012/137338

(57) **Abstract**

The present invention is applied to a resin material and a polymerization method of a polymerization agent having a polymerizable surface structure and a mechanism of supplying the polymerization agent, the polymerization agent exhibiting a polymerizing function in contact with the surface of the resin material. Specifically, the resin material is obtained by living radical polymerization of a radical polymerization initiator exhibiting living property and an unsaturated monomer capable of radical polymerization with the polymerization initiator. The polymerization agent supplied from the outside or the inside of the resin material is brought into in contact with the surface of the resin material to induce radical re-polymerization of the polymerization agent. As a result, the damaged portion of the resin material can be repaired or the resin materials can be bonded to each other by way of the polymerization agent, which can contribute to suppress formation of the hetero-interface or improve the service life of the resin material.

## Description

### Technical Field

The present invention relates to a resin material, a manufacturing method thereof, a repairing method thereof, and various components using the same.

### Background Art

Materials used for products, parts, etc. are selected by taking properties of materials into consideration in view of required function, strength, working circumstance, etc. However, damage, deformation, deterioration, embrittlement, etc. proceed from the outside of the material due to load and continuous use for a long period of time, and the materials finally results in destruction. Although the time elapsing until the destruction of the materials is different depending on working circumstance, kind of materials, etc., any material usually has so-called "material life time". Accordingly, to ensure the kind of structures, safety and reliability of apparatus, etc., it is extremely important to select long life materials, and, among others, it is particularly important to select materials in consideration of the working circumstance and service life.

Since organic materials, such as resin materials mainly comprising hydrocarbons, usually have strength lower than that of inorganic materials comprising metals, ceramics, etc., they tend to suffer damage and deformation. Further, the organic materials such as resin materials deteriorate, resulting in irreversible denaturation, decomposition at the molecular level, etc. accompanied by reduction of mass. Usually it is difficult to restore the organic material having suffered such deterioration.

To address the subjects described above, development of resin materials having higher strength and higher heat resistance has been discussed for the purpose of extending application conditions and improving the material service life. For example, following high functional resin materials having high heat resistance and high strength referred to as engineering plastics are developed: polyacetal (POM), polyamide (PA), polycarbonate (PC), (modified) polyphenylene ether (PPE), polybutylene terephthalate (PBT), etc.), and super engineering plastics (for example, polyphenylene sulfide (PPS), polyether ether ketone (PEEK), polyimide (PI), polyetherimide (PEI), liquid crystal polymers (LCP), etc. Further, studies on composite materials formed by composition of resin materials to each other (polymer alloy), composition of resin materials and inorganic materials, etc. have also progressed and such high performance resin materials have been generalized also in daily life.

However, since the high functional resin materials have high heat resistance and high strength, they involves difficulty in fabrication of the materials while energy consumed during manufacture, discarding, and recycling usually increases more than that for conventional general-purpose resins. This is because resin materials "endurable" to external force were designed, which can be said to be in return for an increase in strength, higher heat resistance, and longer service life.

Further, even a resin material having high strength, suffers damage and deformation when undergoing a force larger than an allowable external force. The thus damaged portion tends to become brittle as in conventional materials and thus it is usually difficult to recover the fractured structure to the original structure as described above.

To address the subjects described above, a technique of providing a resin material with a self-repairing property thereby spontaneously repairing minute fractured portions in the resin has been proposed in recent years. For example, Patent Document 1 describes a composite material containing a polymer, a polymerization agent, a protected activation agent corresponding to the polymerization agent, and a plurality of capsules. The polymerization agent is present in the capsule, and the corresponding activation agent is protected by a corresponding encapsulating agent for the polymer and the polymerization agent. Further, Patent Document 2 describes a composite material containing a polymer matrix and a plurality of capsules containing a polymerization agent and a corresponding activation agent to the polymerization agent.

Further, in connection with the polymerization, Patent Document 3 and Non-Patent Document 1 describe a polymerization initiator utilizing living polymerization.

Further, Patent Document 4 describes a resin material incorporating a monomer as a polymerization agent in a capsule while Patent Document 5 describes a repairing type microcapsule that incorporates a polymeric repairing agent.

### Prior Art Literature

### Patent Document

Patent Document 1: JP-2007-536410-T
Patent Document 2: JP-2008-540733-T
Patent Document 3: JP-2004-83727-A
Patent Document 4: US Patent No. 6518330
Patent Document 5: JP-2007-222807-A

### Non-Patent Document

Non-Patent Document 1: Polymer Preprints, Japan Vol. 64, No. 1, IPb004, (2005)

### Summary of the Invention

### Problem to be Solved by the Invention

However, the techniques described in the prior art references involve the following subjects. That is, in the techniques described in the prior art references, the strength of the resin material after repair is still insufficient. Accordingly, when a component is manufactured by using a conventional resin material, there is a subject that the durability of the manufactured component against external stress is still low.

Further, in the techniques described in the Patent Documents 1 and 2, while the repairing function is provided by the contact between the catalyst and the polymerization agent in the microcapsule, the catalyst has to be dispersed sometimes uniformly and in a sufficient amount in the resin material. However, dispersion (composition) of the catalyst in such an excessive amount may possibly lower the function (for example, strength, glass transition temperature, etc.) of the resin material. Further, the resin that fills the fractured portion is a hardened product of the polymerization agent (specifically, polysiloxane which is a ring-opened metathesis polymer of polydimethylsiloxane), and a hetero-interface boundary is formed between the substrate and the repaired portion. Accordingly, peeling at the boundary tends to occur and no sufficient resin strength and heat resistance can be provided to the repaired portion.

The present invention has been accomplished in view of the foregoing subjects and it intends to provide a resin material improved more for the strength and the heat resistance after repair upon fracture than in conventional materials as well as a manufacturing method thereof, a repairing method thereof, and various components using the same.

### Means for Solving the Problem

The present inventors have made an earnest study for solving the subjects, and found that the subjects can be solved by using a resin material containing a resin formed by living radical polymerization, thereby completing the present invention.

### Effects of the Invention

The present invention can provide a resin material improved more for the strength and the heat resistance after repair upon fracture than conventional materials, as well as a manufacturing method thereof, a repairing method thereof, and various components using them.

### Brief Description of the Drawings

Fig. 1 is a schematic view illustrating a repairing mechanism for a self-repairing function of a resin material according to an embodiment.
Fig. 2 is a schematic view illustrating a repairing mechanism for the self-repairing function of the resin material according to the embodiment in which capsules incorporating a polymerization agent (polymerization agent incorporating capsule) are dispersed (composited).
Fig. 3 is a schematic view illustrating a method of bonding resin materials each other by using a polymerization agent.
Fig. 4 is a schematic view illustrating a cross section of a cable using a resin material according to the embodiment as a cable coating material.
Fig. 5 is a schematic view illustrating a package of an electronic part using the resin material according to the embodiment as a molding sealant.
Fig. 6 is a schematic view illustrating a motor using the resin material according to the embodiment as a protection material for motor coils.
Fig. 7 is a schematic view illustrating a mobile phone using the resin material according to the embodiment as a casing.
Fig. 8 is a schematic view illustrating a re-bonding method of a resin material for evaluating repair of the resin material.
Fig. 9 illustrates a state in which a fractured resin material is re-bonded in an example.
Fig. 10 is a schematic view illustrating a re-bonding method of two resin materials for evaluating repair of the resin material in an example.
Fig. 11 is a photograph as a substitute for drawings of polymerization agent encapsulating capsules obtained in an example.
Fig. 12 is a schematic view illustrating a re-bonding method of a resin material for evaluating repair of the resin material in which a polymerization agent incorporating capsules are dispersed in an example.

### Mode for Carrying Out the Invention

Modes for carrying out the invention (embodiments) are to be described below but the embodiments are not restricted to the following matters but can be practiced by optional modification within a range not impairing the gist of the invention.

### 1. Resin material

A resin material according to the embodiment contains a resin formed by living radical polymerization of an unsaturated monomer which is polymerizable by a radical polymerization initiator. Upon fracture of the resin material, the resin material has a self-repairing function in which, when sites capable of initiating radical polymerization are present at a fracture surface formed by the fracture and an unsaturated monomer capable of radical polymerization with the sites is brought into contact with the sites, radical polymerization of the unsaturated monomer to the sites is performed.

### 1-1. Starting material and manufacturing method

The unsaturated monomer constituting the resin material according to the embodiment is not particularly restricted so long as it is an unsaturated monomer having an unsaturated bond and capable of radical polymerization. That is, the resin material according to the embodiment is obtained by radical polymerization of any optional known unsaturated monomers capable of radical polymerization.

In the present specification, "unsaturated monomer constituting the resin material" means an unsaturated monomer that forms repetitive units in a resin material when such unsaturated monomers are polymerized to form the resin material. For example, the unsaturated monomer constituting a polystyrene as the resin material is styrene.

This is identical also in a case where the resin material is, for example, a copolymer such as a block polymer. However, when the copolymer is, for example, a random copolymer, the repetitive units as described above are not sometimes generated. Also in such a case, the unsaturated monomer used upon manufacture of the resin material is regarded as "unsaturated monomer constituting the resin material".

Examples of the unsaturated monomer include low molecular weight unsaturated monomers having radically polymerizing functional group such as a vinyl group, and polymerizing unsaturated monomers of a relatively high molecular weight used for so-called electric insulation varnishes such as unsaturated polyester and epoxy vinyl ester. Further, there are no particular restrictions for the structures of unsaturated monomers, for example, monofunctional unsaturated monomers not forming a crosslinking structure by themselves, and poly-functional unsaturated monomers having a plurality of polymerizing sites referred to as crosslinkers.

Specific examples of the unsaturated monomers include aromatic vinyl compounds such as styrene, α-methylstyrene, o-methylstyrene, m-methoxy styrene, o-chlorostyrene, m-chlorostyrene, N,N-dimethyl-p-amino styrene, and divinylbenzene; alkyl(meth)acrylates such as methyl(meth)acrylate, ethyl(meth)acrylate, n-propyl acrylate, n-butyl acrylate, 2-ethylhexyl(meth)acrylate, and stearyl(meth)acrylate; unsaturated monocarboxylic acid esters such as methyl crotonate, ethyl crotonate, methyl cinnamate, and ethyl cinnamate; fluoroalkyl(meth)acrylates such as trifluoroethyl (meth)acrylate, pentafluoropropyl (meth)acrylate, and heptafluorobutyl (meth)acrylate; siloxanyl compounds such as trimethyl siloxanyl dimethyl silyl propyl (meth)acrylate, tris(trimethylsiloxyanyl) silylpropyl (meth)acrylate, and di(meth)acryloyl propyl dimethylsilyl ether; monomers or di-(meth)acrylates of alkylene glycols such as ethylene glycol, 1,2-propanediol, 1,3-propanediol, 1,6-hexanediol; alkoxyalkyl(meth)acrylates such as 2-methoxy-ethylene (meth)acrylate, 2-ethoxyethyl (meth)acrylate, 3-ethoxypropyl (meth)acrylate; cyano compounds, for example, cyanoalkyl (meth)acrylates such as cyanoethyl (meth)acrylate and cyanopropyl (meth)acrylate, and acrylonitrile, and methacrylonitrile; oligo(meth)acrylates of polyhydric alcohols, for example, di(meth)acrylates, tri(meth)acrylates, or tetra(meth)acrylates of polyhydric alcohols such as glycerin, 1,2,4-butane triol pentaerythritol, trimethylol alkanes (number of carbon atoms in the alkane is, for example, 1 to 3), tetramethylol alkane (number of carbon atoms in the alkane is, for example, 1 to 3); hydroxyl alkyl(meth)acrylates such as 2-hydroxyethyl (meth)acrylate, 2-hydroxypropyl (meth)acrylate, and 3-hydroxypropyl (meth)acrylate; hydroxyl alkyl esters of unsaturated carboxylic acids such as 2-hydroxyethyl crotonate, 2-hydroxtpropyl crotonate, and 2-hydroxypropyl cinnamate; unsaturated alcohols such as (meth)allyl alcohol; unsaturated (mono)carboxylic acids such as (meth)acrylic acid, crotonic acid, and cinnamic acid; unsaturated polycarboxylic acids (anhydride) such as (anhydrous)maleic acid, fumaric acid, (anhydrous)itaconic acid, and citraconic acid; and mono or diesters thereof; epoxy group-containing unsaturated compounds such as allyl glycidyl ether, and glycol (meth)acrylate; diene compounds such as butadiene, and isoprene; vinyl chloride, vinyl acetate, sodium isoprene sulfonate, cinnamic acid esters, crotonic acid esters, dicyclopentadiene, and ethylidene norbornene.

Among them, preferred examples of unsaturated monomers applicable to the resin material according to the embodiment include: aromatic vinyl compounds, alkyl (meth)acrylates, unsaturated monocarboxylic acid esters, fluoroalkyl (meth)acrylates, siloxanyl compounds, alkylene glycol mono- or di-(meth)acrylates, alkoxyalkyl (meth)acrylates, cyanoalkyl (meth)acrylates, cyano compounds, oligo (meth)acrylates of polyhydric alcohols, hydroxyalkyl (meth)acrylates, hydroxyalkyl esters of unsaturated carboxylic acids, unsaturated alcohols, unsaturated (mono)carboxylic acids, unsaturated polycarboxylic acids or unsaturated polycarboxylic acid anhydrides, mono- or diesters of unsaturated polycarboxylic acid or unsaturated polycarboxylic acid anhydrides, epoxy group-containing unsaturated compounds, diene compounds, vinyl chloride, vinyl acetate, sodium isoprene sulfonate, cinnamic acid esters, crotonic acid esters, dicyclopentadiene, and ethylidene norbornene.

Further, the unsaturated monomers may be optionally substituted by any substituent.

Further, the unsaturated monomers are not necessarily used alone. Accordingly, two or more of them may be used at any ratio and combination considering, for example, the performance of the resin material such as strength (for example, tensile strength and bending strength), glass transition temperature, and decomposition temperature, material cost, reactivity, etc.

The radical polymerization initiator used upon manufacture of the resin material according to this embodiment is not particularly restricted to specific kind so long as the initiator is a compound capable of causing living radical polymerization to the unsaturated monomer. As the radical polymerization initiator usable in this embodiment, however, an alkyl borane is particularly preferred. Use of the alkyl borane as the radical polymerization initiator provides an advantage that radical polymerization function at the end of radical polymerization is not inactivated for a long time even when the obtained resin material is exposed to air (more specifically oxygen).

The kind of the alkyl borane is not particularly restricted and includes, for example, alkoxy boranes such as diethylmethoxyborane, trimethoxyborane, tri-n-butoxyborane, and cathecolborane; trialkylboranes such as triethylborane, triphenylborane, tri-n-butylborane, tri-sec-butylborane, and tri-tert-butylborane; and dialkylboranes such as siamylborane, and bicycle[3.3.1]nona-9-borane (9-BBN). Among them, diethylmethoxyborane and 9-BBN are more preferred with diethylmethoxyborane being particularly preferred. They may be substituted with one or more optional substituent.

Further, the radical polymerization initiators may be used each alone or two or more of them may be used at any ratio and in any combination.

Then, the resin material according to this embodiment can be obtained by living radical polymerization of the unsaturated monomer by using the radical polymerization initiator as described above. There is no particular restriction on the specific method upon living radical polymerization. Accordingly, living radical polymerization may be performed by any known method of living radical polymerization reaction.

However, when the amount of the radical polymerization initiator is insufficient, preferred self-repairing function may not be possibly provided to the obtained resin material. Accordingly, the concentration of the radical polymerization initiator is preferably 1 mass% or more based on the amount of the unsaturated monomer.

Also the polymerization temperature and the polymerization atmosphere are not particularly restricted during living radical polymerization. The resin material according to this embodiment can be obtained by performing polymerization, for example, at a temperature of about 60°C or higher and 120°C or lower for one hour or more and three hour or less, although they cannot be defined generally since they are different depending on the type and the amount of use of the unsaturated monomer and the type of the radical polymerization initiator. It is not necessary to maintain the temperature during polymerization always at a constant temperature during polymerization but polymerization may be conducted while optionally changing the temperature.

Further, also the atmosphere during polymerization is not particularly restricted and polymerization can be performed, for example, in atmospheric air (air atmosphere).

So long as the resin material according to the embodiment has the self-repairing function described above, other properties of the material are not particularly restricted. Accordingly, the resin material of this embodiment may be, for example, a thermoplastic resin or a thermosetting resin. Therefore, since the property of the resin material is usually determined depending on the type of the unsaturated monomer, the type of the unsaturated monomer may be determined such that the obtained resin material has desired properties.

Further, when two or more unsaturated monomers are polymerized, the property of the resin material changes compared with the case in which a single unsaturated monomer is polymerized. For example, when two or more unsaturated monomers are polymerized, the obtained resin material is a copolymer and such copolymer includes polymerization forms such as random copolymer, alternating copolymer, block copolymer, graft copolymer, etc. The property of the obtained resin material usually changes also depending on the form of polymerization. Accordingly, it is possible to provide a resin material excellent than usual, which has a self-repairing function to be described specifically below and various high functions (for example, heat resistance, light fastness, waterproofness, high rigidity (high strength), long life, chemical resistance, etc.) of the resin material together.

### 1-2. Repairing mechanism

The self-repairing function upon fracture of the resin material obtained by the starting material and the manufacturing method described above, which is obtained according to the investigation of the present inventors will next be described with reference to the drawings. As described above, upon fracture of the resin material, the self-repairing function is such that, when sites capable of initiating radical polymerization are present at a fracture surface formed by the fracture and an unsaturated monomer capable of radial polymerization with the sites is brought into contact at the sites, radical polymerization of the unsaturated monomer to the sites is performed.

First, the purpose of the present inventors to achieve the present invention is to be described.

As described above, since resin materials having high strength and high heat resistance such as engineering plastics are difficult for molding and fabrication and, in addition, since the resin material per se has no repairing-function, once the material suffers damage, it is difficult to recover the original structure. Then, it is intended to design a "healing" resin material capable of repairing damaged portions, that is, to design a resin material having a repairing function with an aim of escaping from the existent design for resin materials so far.

However, the prior art resin material techniques described in the prior art references involve a subject in view of the composition of the polymerization agent, etc. and low resin strength and heat resistance after repair and they are still insufficient in view of repair of the resin material and it is considered that there remains a room for improvement.

Specifically, in any of the resin materials, for performing polymerizing reaction of the polymerization agent, it is necessary for additional compositing, for example, of a polymerization catalyst such as a Grubbs catalyst and an organic metal catalyst to a resin material (refer to the prior art references). Further, since the polymerization catalyst should be covered, for example, by wax, encapsulation, etc. with an aim of maintaining the activity of the polymerization catalyst, this makes the procedures complicate and difficult to handle.

Further, in the existent techniques, since it is necessary to investigate also the compositing amount and the dispersion method of the catalyst and the polymerization agent upon development of uniform repairing function is necessary, there may be a room for improvement also considering the catalyst cost, etc. Further, no sufficient resin strength has yet been provided to the repaired portion in the resin material, so that there is also a subject in view of the low resin strength after repair.

The present inventors have made a study in view of the above and developed a resin material by a simple system with less number of materials necessary for repair and exhibiting resin strength and glass transition temperature (index for heat resistance) which are identical before and after repair. As a result, the present inventors have noted on three factors, i.e., (1) a resin material system capable of repairing damaged portions (fractured portions) and having a novel repairing function, (2) a simple material system with less number of materials (or not containing materials) necessary for repair, and (3) a resin material system exhibiting a resin strength and a glass transition temperature, which are substantially identical before and after repair as indices for the resin material having the repair function and have found a self-repairing function by a living radical polymerization resin.

The self-repairing function of the resin material according to this embodiment obtained as a result of the earnest study made by the present inventors is to be described.

In the resin material according to this embodiment, when the fracture surface formed upon fracture is exposed to air, the radical polymerization ends present (formed) at the fracture surface are activated and show polymerizing reactivity at the fracture surface. "Fracture surface" is formed, specifically, when the resin material suffers damage, deformation, breakage, scratch, destruction, tearing, cutting, disconnection, degradation, decomposition, molding, deposition, etc.

When the polymerization agent is supplied to the resulting fracture surface, radical polymerization is induced and radical polymerization proceeds between the unsaturated monomer contained in the polymerization agent and the radical polymerization end present at the fracture surface. Thus, a resin repairing film is formed newly at the fracture surface. "Supply" of the polymerization agent represents, specifically, coating, injection, dipping, spraying; printing, transfer, bonding by using rolls, etc. and coating, injection, and dipping are particularly, preferred.

In the technique, for example, described in the prior art reference, a catalyst for polymerization was previously dispersed in the resin material. In the embodiment of the invention, since re-polymerization of Dormant species as the terminal end group of the living radical polymerization of the resin material is utilized for polymerization (repair), it is not necessary to incorporate the catalyst in the resin material, the polymerization agent, etc. Further, it is considered that the Dormant species are contained throughout the sites in the resin material and self-repair is possible against fracture of the resin material at any site. Accordingly, dispersion of the polymerization catalyst, etc. into the resin material is not necessary also from this view point. That is, this embodiment can provide the self-repairing function to the resin material with no problems described above.

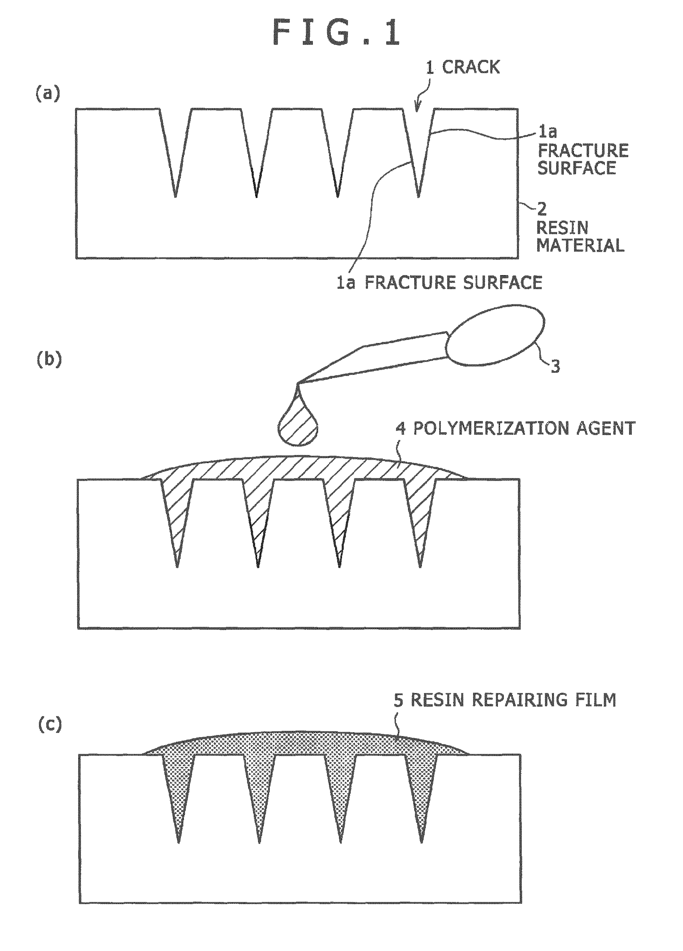

The self-repairing function is to be described for a specific example with reference to Fig. 1. As shown in Fig. 1(a), it is assumed that a resin material 2 according to this embodiment is fractured to form cracks 1 and form opposing fracture surfaces 1a, 1a. Then, as shown in Fig. 1(b), a polymerization agent 4 containing an unsaturated monomer is coated so as to cover the cracks 1 by a syringe 3. Then, radical polymerization is taken place between the polymerization agent present between the two fracture surfaces 1a, 1a and the fracture surface 1a, and a resin repairing film 5 is formed newly in the inside of the crack 1 (Fig. 1(c)). When the resin repairing film 5 is formed, the polymerization rate can be promoted by heating the resin material 2 containing the polymerization agent 4. As a result, the resin can be hardened more rapidly by heating. Further, the resin can be hardened more intensely by the heating.

In the thus formed resin coating film 5, when the unsaturated monomer contained in the polymerization agent 4 and the unsaturated monomer constituting the resin material 2 are, for example, identical, the resin strength and the glass transition temperature of the resin material 2 after repair are substantially identical with the resin strength and the glass transition temperature of the resin material 2 before repair. Specifically, the reduction ratio in the strength of the resin material (that is, resin strength) after repair is usually within 10%, preferably, 5% and, more preferably, 1% of the strength of the resin material before repair. The strength of the resin material can be measured, for example, by a precision universal tester autograph (AGS-100G manufactured by Shimazu Corporation).

Further, the reduction ratio of glass transition temperature by analysis for thermo-mechanical property after repair is usually within 10%, preferably 5% and, more preferably, 1%. This is estimated that the living radical polymerization ends present at the surface of the fracture surface 1a and the unsaturated polymer in the polymerization agent 4 are integrated by polymerization thereby reproducing a chemical structure identical with that of the resin material before repair. The thermo-mechanical property can be analyzed by using, for example, a thermo-mechanical testing unit TM-9300, manufactured by ULVAC Inc.

The unsaturated monomer contained in the polymerization agent 4 may be identical with or different from the unsaturated monomer constituting the resin material 2. Also in a case where the unsaturated monomer contained in the polymerization agent 4 is different from the unsaturated monomer constituting the resin material 2, the same effect is provided as in the case where they are identical. However, the unsaturated monomer contained in the polymerization agent 4 is preferably identical with the unsaturated monomer constituting the resin material 2. Further, when an unsaturated monomer different from the unsaturated monomer constituting the resin material 2 is used, the unsaturated monomer contained in the polymerization agent 4 is preferably easily polymerizable with the unsaturated monomer constituting the resin material 2.

The viscosity of the polymerization agent 4 is not particularly restricted but it is preferably 0.001 Pa·s and, more preferably, 0.005 Pa·s or more in view of the diffusion of the polymerization agent 4 at the surface of the resin material 2. The upper limit is preferably 1 Pa·s or less and, more preferably, 0.1 Pa·s or less. If the viscosity is insufficient, the polymerization agent 4 may possibly flow out to the outside of the resin material 2 without being kept at the crack 1. When the viscosity is excessive, there may be a possibility that the polymerization agent 4 is not diffused sufficiently to the inside of the crack 1.

While the polymerization agent 4 may contain an ingredient inducing radical polymerization such as radical generator and a radical polymerization initiator, it is particularly preferred that such ingredient is not contained. When such ingredient is not contained in the polymerization agent 4, radical polymerization can be taken place only when the unsaturated monomer contained in the polymerization agent 4 is in contact with the fracture surface 1a and a resin repaired layer 5 can be formed more reliably and firmly.

In the resin material obtained, for example, by living radical polymerization using an alkyl borane as a radical polymerization initiator, it has been found by the investigation made by the present inventors that the radical polymerization initiator repeat hydroboration - spontaneous oxidation repetitively. As a result, it is considered that covalent bond species (Dormant species) are formed at radical growing ends, and polymerization proceeds while generating radicals reversibly. Therefore, as long as the Dormant species can be maintained, re-polymerization at the growing ends are possible without losing activity. Further, it is considered that the resin material obtained by the living radical polymerization has excellent self-repairing function utilizing such living radical property and provides a remarkable progress for improving the service life of the resin material.

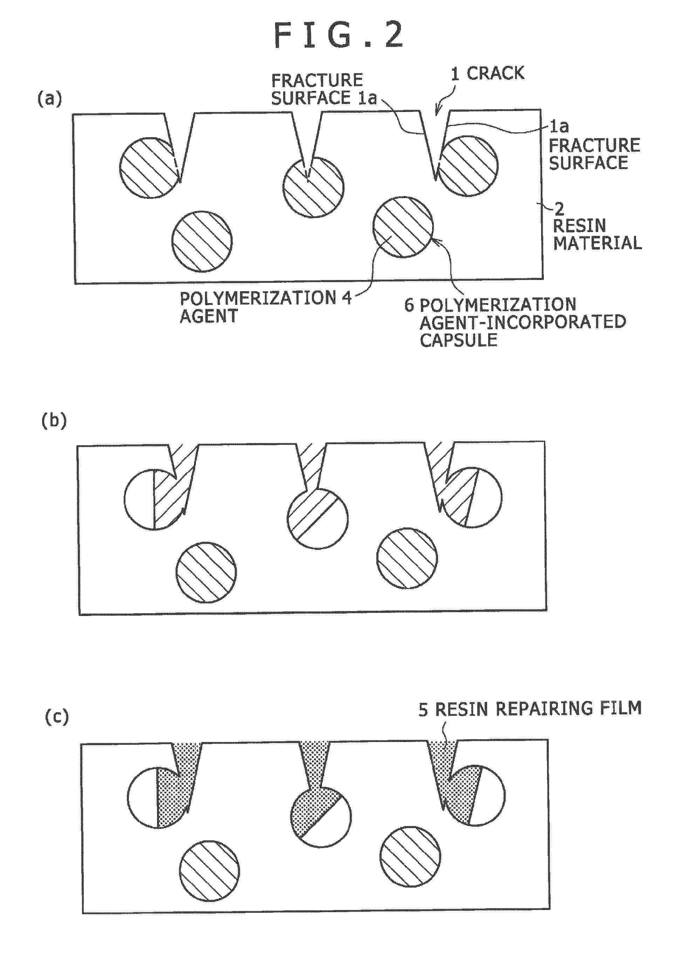

Then, another embodiment where the polymerization agent is supplied to cracks is to be described with reference to Fig. 2. Components identical with those illustrated in Fig. 1 carry the same reference numerals, for which duplicate description is to be omitted.

In the embodiment illustrated in Fig. 2, polymerization agent-incorporated capsules (vessels) 6 each incorporating a polymerization agent 4 are previously dispersed (composited) to the resin material 2. That is, before generation of cracks 1 in the resin material 2, the resin material 2 and the polymerization agent 4 are kept from contact to each other by a film that constitutes the polymerization agent-incorporated capsule 6. Then, when cracks 1 are formed in the resin material 2 described above, the fracture surface 1a reaches the polymerization agent-incorporated capsule 6 to break the polymerization agent-incorporated capsule 6 (Fig. 2(a)). As a result, the polymerization agent 4 leaks from the polymerization agent-incorporated capsule 6 to fill the inside of the crack with the polymerization agent 4 (Fig. 2(b)). Radical polymerization proceeds in this state in the same manner as illustrated in Fig. 1 and a resin repairing film 5 is formed in the crack 1 (Fig. 2 (c)).

The polymerization agent-incorporated capsule 6 in the embodiment illustrated in Fig. 2 is a hollow vessel that incorporates the polymerization agent 4. The size, shape, etc. of the polymerization agent-incorporated capsule 6 are not particularly restricted. However, the polymerization agent-incorporated capsule 6 has a particle shape, and the average particle size is preferably 10 nm or more, more preferably, 30 nm or more and further preferably, 50 nm or more. The upper limit thereof is, preferably, 1 mm or less, more preferably, 500 µm or less and, further preferably, 300 µm or less. The average particle size of the polymerization agent-incorporated capsules 6 can be measured, for example, based on a photograph taken by a scanning electron microscope (SEM).

Also the thickness of the polymerization agent-incorporated capsule 6 is not particularly restricted and it is preferably 1 nm or more and, more preferably, 5 nm or more, and the upper limit of the thickness is preferably 3 µm or less and, more preferably, 1 µm or less. When the thickness is excessively thin, the capsule may possibly be destroyed when the resin material 2 is manufactured and capsules are dispersed therein. Further, when the thickness is excessively large, there may be a possibility that the capsule is not broken even when the crack reaches the capsule and the polymerization agent does not leak. Since the preferred thickness of the polymerization agent-incorporated capsule 6 is different depending on the kind of the resin material 2, it cannot be determined generally but may be changed properly in accordance with the conditions conforming to the self-repairing function and required performances.

For enhancing the affinity and the adhesion between the surface of the polymerization agent-incorporated capsule 6 and the resin material 2, the surface of the polymerization agent-incorporated capsule 6 may be optionally treated by a coupling agent or the like. Further, in the embodiment illustrated in Fig. 2, a hollow capsule is used as a vessel for incorporating the polymerization agent. For example, a tubular glass capillary vessel sealed on both ends, a hollow film layer, etc. are applicable as a vessel for incorporating the polymerization agent. However, the configuration of using the capsule illustrated in Fig. 2 is particularly preferred with a view point that the capsule can be manufactured easily by a solvent evaporation method.

The method of manufacturing the polymerization agent-incorporated capsule 6 is not particularly restricted. A method of manufacturing a resin material 2 containing the polymerization agent-incorporated capsule 6 in this embodiment is to be described with reference to a specific example.

First, a method of manufacturing the polymerization agent-incorporated capsule 6 is to be described. The polymerization agent-incorporated capsule 6 is produced mainly by way of (1) a step of preparing an oil-in-water emulsion (O/W: state in which oil droplets are dispersed in water) (emulsion preparation step), (2) a step of removing an organic solvent of the organic phase (oil droplet) from the emulsion (solvent evaporation step), and (3) a step of filtration, washing, and drying.

### (1) Emulsion preparation step

In this step, an O/W type emulsion is prepared by mixing an organic solution comprising an organic phase containing a polymerization agent, a film forming material for incorporating the polymerization agent, and an organic solvent, and an aqueous solution comprising an aqueous phase containing a dispersant dissolved therein. In this case, a stabilizer, a hardening accelerator, etc. are optionally added to the organic phase.

Since the polymerization agent used in this step is identical with that of the polymerization agent 4 described above, description therefor is to be omitted.

The film forming material contained in the organic solution is not particularly restricted and includes, for example, resin materials such as polymethyl methacrylate, hardened melamine resin product, hardened urea resin product, and hardened epoxy resin product; and inorganic materials such as silica and alumina.

The organic solvent is not particularly restricted and includes, for example, isooctane, dichloromethane, dichloroethane, and ethyl acetate.

Further, the dispersant and the hardening accelerator added optionally are not particularly restricted and include, for example, sorbitan monooleate.

The compounds may be used each alone or two or more of them may be used at any ratio and in any combination.

On the other hand, the dispersant contained in the aqueous solution is not particularly restricted and examples thereof include, for example, nonionic surfactants such as polyvinyl alcohol, tertiary calcium phosphate, polyoxyethylene lauryl ether, polyoxyethylene oleyl ether, polyoxyethylene nonylphenol ether, sorbitan monolaurate, sorbitan tristearate, polyoxyethylene sorbitan monolaurate, and polyoxyethylene sorbitan monooleate; anionic surfactants such as sodium lauryl sulfate, and sodium dodecyl benzene sulfonate; cationic surfactants such as lauryl trimethyl ammonium chloride and stearyl trimethyl ammonium chloride; water soluble polymeric compounds such as polyvinyl alcohol, sodium polyacrylate, polyvinyl pyrrolidone, and carboxymethyl cellulose; and natural polymers such as starch and gelatin. They may be used each alone or two or more of them may be used at any ratio and in any combination.

Amounts of the polymerization agent and each of other ingredients, stirring and mixing conditions such as stirring time and stirring device when preparing the emulsion are not particularly restricted and may be determined properly so that a desired size of oil droplets is obtained (for example, particle size of about several tens µm to several mm). Then, a state in which the oil droplets are dispersed in the aqueous solution can be attained by stirring and mixing the polymerization agent, the organic solution, and the aqueous solution. The polymerization agent is contained in the oil droplet and the surface of the oil droplet is covered with the film forming material.

### (2) Solvent evaporation step

In this step, the emulsion is depressurized (for example, at about 30 kPa by absolute pressure) at a predetermined temperature (about 35°C) and the organic solvent, etc. in the oil droplet are gradually removed for about 3 hours to 24 hours. Then, when the desired size of the oil droplets is obtained, the obtained emulsion after aggregation is subjected to the next filtration, washing and drying step.

### (3) Filtration, washing and drying step

In this step, the solution containing the emulsion after aggregation obtained in the solvent evaporation step is centrifugated to separate oil droplets. The oil droplets may also be separated, for example, by filtration. Then, the separated oil droplets are washed, for example, by using an aqueous solution of 0.5 M hydrochloric acid to remove deposits such as dispersant. Subsequently, by drying the oil droplets after washing (spontaneous drying or freeze drying), a polymerization agent-incorporated capsule 6 in which the polymerization agent 4 is incorporated can be obtained.

Then, after the mixing of the thus obtained polymerization agent-incorporated capsule 6, the radical polymerization initiator, and the unsaturated monomer constituting the resin material 2, the unsaturated monomer constituting the resin material 2 is subjected to living radical polymerization, by which the resin material 2 illustrated in Fig. 2 can be formed. In the thus formed resin material 2, the polymerization agent 4 contained in the polymerization agent-incorporated capsule 6 leaks to the crack 1 upon fracture and a resin repairing film 5 is formed.

### 2. Application range and use of resin material

As described above, in the resin material according to this embodiment, mechanical damage of the resin material can be self-repaired by introducing the self-repairing function, which allows to improve the service life and the resin strength of the resin materials, and maintain the heat resistance thereof. Use of such self-repairing function is useful not only for the repair of the resin strength by bonding the resin material but also as a technique of repairing damages at a micro level and preventing damages from growing to those of a visible level.

For example, the resin material is sensitive to abrupt thermal change and may sometimes cause micro cracks by repeating thermal changes. Micro cracks per se are joined to each other to grow into a larger crack, which leads to damage and destruction of the resin material. Further, since the micro cracks are difficult to be observed visually, once they are generated, discovery and repair of them are difficult. However, in the resin material according to this embodiment, since such micro cracks can also be self-repaired even if they are generated, the resin material is extremely useful in which there is scarce possibility of growth to larger crack, damage, and destruction.

The application use of the resin material according to this embodiment is not particularly restricted and includes, for example, those parts used under conditions of suffering external damage and violent temperature change, specifically, cable coating materials, packages for electronic parts such as mold sealants, protective materials for motor coils, insulation materials for motors and generators, and structural resin materials for casings and resin molding used for electronic instrument.

Further, the resin material according to this embodiment can be easily applied also to fiber-reinforced plastics (FRP) by compositing the resin material, for example, with base materials such as fibers, glass clothes, etc. Accordingly, the self-repairing function of the resin material that utilizes the self-repairing function of the resin material according to this embodiment is applicable also to the field where the material strength is demanded particularly.

Further, the material is applicable to extremely wide range of fields to which the resin material is concerned such as for those parts which are impossible or difficult to repair, for example, resin materials for space development such as satellite rockets, materials for artificial internal organs, structural materials used for aircrafts, railways, automobiles, vessels and building materials, and films having self-repairing function applicable to protective layers of display devices, etc.

Further, the resin material according to this embodiment may be a thermosetting resin or a thermoplastic resin as described above. Particularly, also for hardened products of thermosetting resin of poor workability, the resin strength is recovered to a level about identical with that before damaging by performing repair for the damaged portion by way of living radical polymerization.

Since the thermosetting resin has poor workability, the method of repairing a damaged part has been restricted so far to a method of protecting and fixing the damaged portion by using a repairing material such as paint, glue, adhesive, and putty in the conventional repairing technique for the thermosetting resin. In addition, such repairing method involves a problem of tending to cause separation at the boundary between the damaged portion of the resin material and the joined portion of the repairing material. By using the resin material according to this embodiment, since re-polymerization proceeds from the surface at the resin of the damaged portions (cracks), separation at the boundary as in the case of using the existent repairing materials less occurs, and the resin strength can be recovered simultaneously with repair.

Further, the resin material according to this embodiment can be used as a composite material by compositing with other resin (polymer alloy), mixing and compositing with an inorganic material, etc. When the resin material according to this embodiment is used as the composite material, the resin material can be optionally provided with functions that are not obtainable sufficiently by the resin material alone, for example, various functions such as scratch resistance, weather proofness, and low thermal expansion ratio in addition to the resin strength and the heat resistance. Accordingly, the range for the use of such composite materials is extended remarkably.

The kind of the material to be composited is not particularly restricted within a range not impairing the self-repairing function of the resin material according to this embodiment and an optional material is usable. For example, since the surface of the resin material just after polymerization shows the same polymerization reactivity as that at the fracture surface of the cracks, resin materials are bonded to each other by coating the unsaturated monomer to the surface of the resin material. Accordingly, when the self-repairing function of the resin material according to this embodiment is utilized, this is applicable not only to repair at the surface of the resin material but also as a new bonding technique between resin materials to each other.

For example, a structural body such as a model and a casing can be formed by covering the surface of the resin material according to this embodiment with a polymerization agent and stacking and combining the resin materials to each other. Further, the structural body has an integrating function in view of the molecular structure by the living radical polymerization by way of the polymerization agent and a structural body bonded intensely that cannot be obtained by usual adhesion and bonding using an adhesive can be obtained.

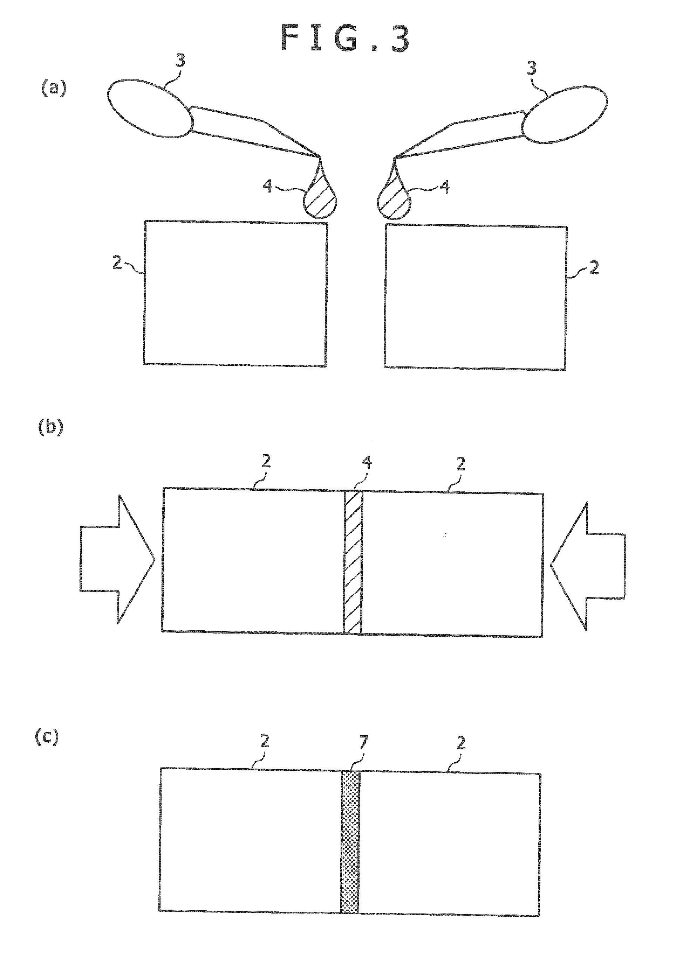

Such a structural body is to be described with reference to Fig. 3. Components identical with those illustrated in Fig. 1 carry the same reference numerals, for which detailed description is to be omitted.

As illustrated in Fig. 3(a), a polymerization agent 4 is coated to both end faces of two resin materials obtained by living radical polymerization by using a syringe 3. Then, as illustrated in Fig. 2(b), surfaces coated with the polymerization agent 4 are brought into close contact to each other. Then, by performing radical polymerization between the both end faces and the unsaturated monomer contained in the polymerization agent 4, the polymerization agent 4 is hardened to form a bonded layer 7 (Fig. 3(c)). The attained bonded layer 7 is formed through covalent bond with the two resin materials 2, 2 by chemical integration, and the resin material formed by bonding the two resin materials has an extremely high strength.

### 3. Specific examples of the use of resin material

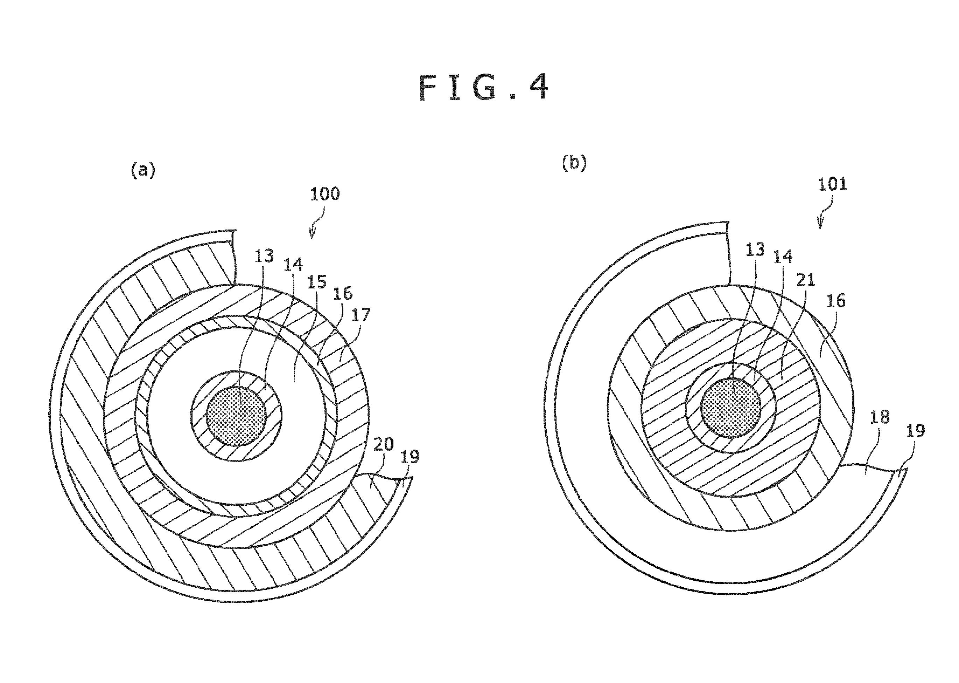

The use of the resin material according to this embodiment is to be described with reference to specific structures in Fig. 4 to Fig. 7.

### 3-1. Cable and cable coating material

Both of Figs. 4(a) and (b) are schematic views illustrating cross sectional structures of cables each having a resin material according to this embodiment. In a cable 100 illustrated in Fig. 4(a), the resin material according to this embodiment is used for a coating layer 20. Further, in a cable 101 illustrated in Fig. 4(b), the resin material according to this embodiment is used for an insulation layer 21. That is, each resin material according to this embodiment is used as a cable coating material. Further, in the insulation layer 21 illustrated in Fig. 4(b), the polymerization agent-incorporated capsules described with reference to Fig. 2 (not illustrated in Fig. 4) may be dispersed.

The cable 100 illustrated in Fig. 4(a) has a conductor 13, an internal semiconductor layer 14, an insulation layer 15, an external semiconductor layer (adhesion layer) 16, an external semiconductor layer (separation layer) 17, a coating layer 20, and an outer skin layer 19. The material constituting the conductor 13 is not particularly restricted and an optional good conductor such as copper or aluminum can be used. Further, the form of the conductor 13 is not particularly restricted and may be in an optional known form such as a solid wire, a twisted wire, etc. Further, also the cross sectional shape of the conductor 13 is not particularly restricted and can be formed, for example, as a circular shape, a divided circular shape, a compressed shape, etc.

The material constituting the internal semiconductor layer 14 and the form thereof are not particularly restricted and any known material may be used.

Further, also the material constituting the insulation layer 15 and the form thereof are not particularly restricted, and oil-impregnated paper or oil-impregnated semi-synthesis paper materials, rubber materials, resin materials, etc. can be used. Examples of the insulation materials, for example, rubber material and resin materials include ethylen-propylelen rubber, butyl rubber, polypropylene, thermoplastic elastomer, polyethylene, crosslinked unsaturated polyethylene, etc. and, among them, polyethylene and crosslinked polyethylene are suitable with a view point that they are used generally for insulated cables.

The external semiconductor layer (adhesion layer) 16 is provided with an aim of moderating an intense electric field generated at the periphery of the conductor 13. Examples of the material used for the external semiconductor layer (adhesion layer) 16 include semiconductive resin compositions comprising resin materials, for example, styrene-butadiene thermoplastic elastomer, polyester elastomer, and soft polyolefin blended with 20 mass% to 70 mass% of conductive carbon black, and conductive paints, etc. with addition of 20 mass% to 70 mass% of conductive carbon. The materials are not particularly restricted so long as they satisfy required performances. The method of forming the external semiconductor layer (adhesion layer) 16 on the surface of the insulation layer 15 is not particularly restricted and includes, for example, continuous extrusion, dipping, spraying-coating, and application depending on the type of the components.

The external semiconductor layer (separation layer) 17 is provided with an aim of moderating an intense electric field generated at the periphery of the conductor 13 and protecting the inner layer in the same manner as the external semiconductor layer (adhesion layer) 16. Further, it may suffice that the layer is easily separated from the external semiconductor layer (adhesion layer) 16 in connection or like other working, and other layer may be interposed therein. Examples of the material used for the external semiconductor layer (separation layer) 17 include, for example, crosslinkable or not-crosslinkable resin composition in which a conductive carbon black is blended by 30 to 100 mass parts based on 100 mass parts of a base material containing at least one of rubber materials such as soft polyolefin, ethylene-propylene rubber, and butyl rubber, and styrene-butadiene thermoplastic elastomer and polyester elastomer. The materials are not particularly restricted so long as they satisfy the required performances. Further, additives such as graphite, lubricant, metal, and filler such as inorganic filler may be properly incorporated depending on the requirement. The method of forming the external semiconductor layer (separation layer) 17 on the surface of the external semiconductor layer (adhesion layer) 16 is not particularly restricted, for which extrusion molding is suitable.

For the coating layer 2, the resin material according to this embodiment as described above is used. Since the resin material according to this embodiment has been described above, explanation therefor is to be omitted.

Any known material can be used for the outer skin layer 19, which is not particularly restricted depending on the kind of the material.

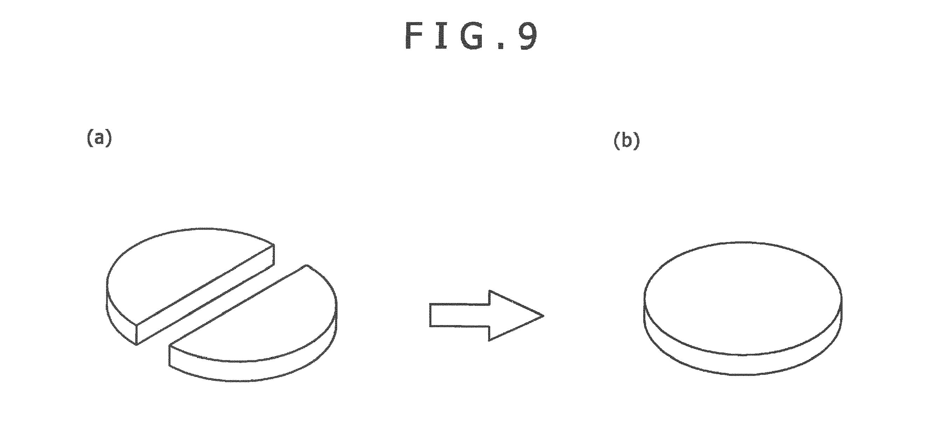

The cable 101 illustrated in Fig. 9(b) is a cable not requiring a separation mechanism of the cable 100 illustrated in Fig. 9(a). Accordingly, the cable 101 comprises only one layer of the external semiconductor layer (adhesion layer) 16. Components for the cable 100 and cable 101 having identical functions carry the same references, for which detailed description is to be omitted.

In the cable 101, the coating layer 18 comprises, for example, a resin material, which comprises any known material. Further, the insulation layer 21 comprises the resin material according to this embodiment described above and contains the polymerization agent-incorporated capsules described in Fig. 2.

Specific examples of both of the cables 100 and 101 also have the resin strength and the heat resistance identical with those of the coating material used so far. In addition, when damages are generated in the resin material such as generation of scratching damages caused by external friction and friction between the external cables to each other, and micro cracks caused by abrupt thermal change during manufacture, use of cable, etc., performance identical with that before damaging can be maintained for the resin strength and the heat resistance, etc. of the damaged portion by supplying a repairing agent from the outer side or the inner side, as well as by an appropriate repairing treatment.

### 3-2. Mold sealant, potting material, package for electronic part

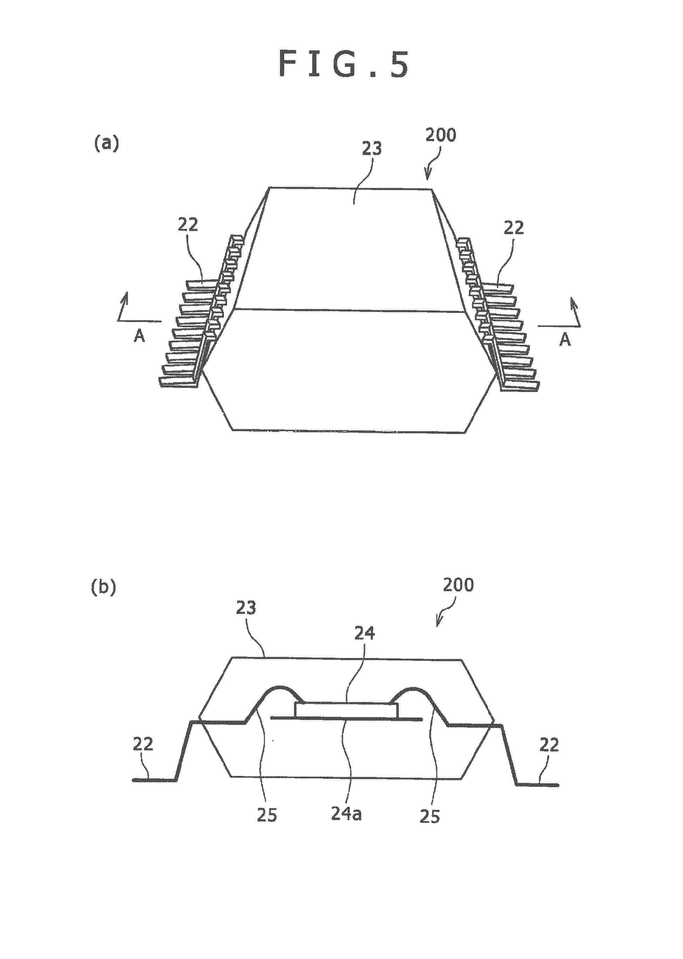

The resin material according to this embodiment is applicable also to a mold sealant, a potting material used for the manufacture of a mold sealant (potting material for manufacturing mold sealant), a package for electronic part, etc. Such specific examples are to be described with reference to Fig. 5. Fig. 5(a) is a perspective view of DIP (Dual Inline Package) 200 as a specific example of a package for electronic part in which the resin material according to this embodiment containing the polymerization agent-incorporated capsule illustrated in Fig. 2 is applied as a mold sealant and Fig. 5(b) is a cross sectional view along line A-A of the DIP 200 illustrated in Fig. 5(a).

The DIP 200 illustrated in Fig. 5 includes a semiconductor device 24 disposed over a substrate 24a, lead frames 22, 22 extending outward of a mold sealant 23, and bonding wires 25, 25 for electrically connecting the lead frames 22, 22, and the semiconductor device 24 and the lead frames 22, 22. A portion of the read frames 22, 22, the semiconductor device 24, the substrate 24a, and the bonding wires 25, 25 are sealed by the mold sealant comprising the resin material according to this embodiment containing the polymerization incorporated capsules illustrated in Fig. 2.

Both of the lead frames 22, 22 and the bonding frames 25, 25 are formed of a good conductor and comprise specifically, for example, copper and aluminum. Further, the form of the lead frames 22, 22 and the bonding frames 25, 25 can be in any known form, for example, solid wires or twisted wires.

As the shape of the semiconductor device 24, for example, a circular shape, a divided circular shape, a compression shape, etc. are applicable. Further, the material for constituting the semiconductor device 24 is not particularly restricted so long as this is a material that can be sealed by the mold sealant 23.

The mold sealant 23 of the DIP 200 maintains the resin strength and the heat resistance substantially identical with those of the conventional materials. In addition, against the damages of the resin material, for example, destruction caused by impact shock to the circuit, generation of micro cracks caused by abrupt thermal change accompanying the heat generation of the circuit, the resin strength and the heat resistance of the damaged portion can be maintained at a level identical with that before damaging by supplying the repairing agent from the inside of the resin and by an appropriate repairing treatment. Further, it has also an advantage that repair is promoted by the heat generated due to current supply to the circuit upon repairing treatment as described above.

A method of mold sealing by using the resin material according to this embodiment (mold sealing method) is to be described. Basically, this is performed by forming the resin material in the same manner as the method of manufacturing the resin material according to this embodiment described above. Specifically, an unsaturated monomer constituting the resin material according to this embodiment, a radical polymerization initiator and, optionally, an organic solvent, etc. are mixed and the semiconductor device 24, etc. are sealed by using the obtained mixture. Thus, the semiconductor device 24, etc. can be sealed.

The mixture before polymerization can be utilized also as a potting material for mold sealing (that is, potting material for use in the application of manufacturing the mold sealant). The potting material is used usually by incorporating, for example, an inorganic filler and other resin material, etc. in addition to the components described above.

The potting material for manufacturing the mold sealant and the mold sealant are applicable to the DIP illustrated in Fig. 5, as well as, also to packages, etc., for example, a lead frame type package such as SOP (System On Package), QFP (Quad Flat Package), etc.; and a package for electronic parts such as BGA (Ball Grid Array), MCP (Multi Chip Package), etc. Further, the mold sealant is applied not only to the semiconductor part but also to mold sealing of electronic part of a size larger than the semiconductor part.

### 3-3. Motor coil protective material, varnish as motor coil protective material, motor

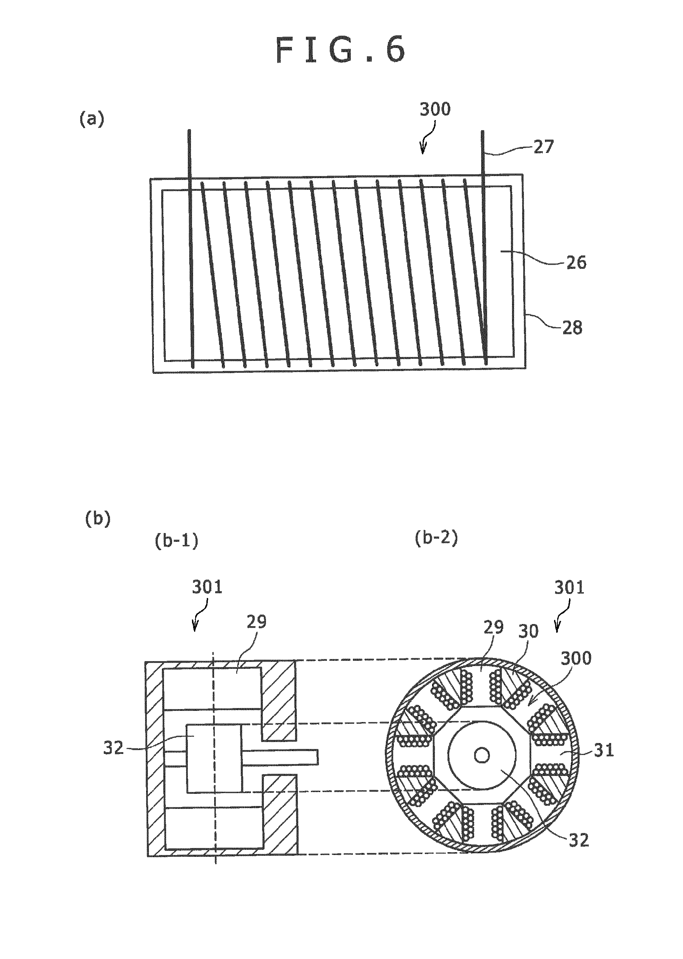

The resin material according to this embodiment is applicable, for example, also to motor coil protective material, varnish for motor coil protective material, motor, etc. Specific examples of them are to be described with reference to Fig. 6. Fig. 6(a) is an upper side elevational view of a motor coil protective material 300, Fig. 6(b) illustrates a cross sectional structure of a motor 301 using the motor protective material 300, Fig. 6(b-1) is a cross sectional view in a direction parallel to the axis of a rotor core 32, and Fig. 6(b-2) is a cross sectional view in a direction perpendicular to the axial direction of the rotor core 32.

The motor coil 300 comprises, as illustrated in Fig. 6(a), a core 26, coated copper wires 27 wound around the core 26, and a motor coil protective material 28 comprising the resin material according to this embodiment. Further, the coil 300 is uniformly coated with the resin material according to this embodiment as a varnish material for the motor coil protective material. For the coating, a method such as dipping, drip-impregnation, etc. can be applied. Further, the varnish material for the motor coil protective material may also incorporate the polymerization agent-incorporated capsules illustrated in Fig. 2.

The core 26 comprises a metal such as iron. Further, an enamel wire of 1 mm diameter is used as the coated copper wire 27. The polymerization agent-incorporated capsules illustrated in Fig. 2 may optionally be incorporated in the protective material 28.

The coil 300 is used for the motor 301 illustrated in Fig. 6(b). The motor 301 includes a cylindrical stator core 30 fixed to the inner edge portion of the motor 301, a rotor core 32 rotated coaxially at the inside of the stator core 30, and eight coils 300 in which coated copper wires are wound in slots 31 of the stator core 30.

The motor 301 using the resin material according to the embodiment maintains identical resin strength and heat resistance with those of the existent materials. In addition, against damages exerting on the resin material such as destruction caused by vibrations and impact shocks during manufacture and use of the motor, generation of micro cracks accompanying abrupt temperature change upon operation and stopping of the motor, the resin strength and the heat resistance of the damaged portions can be maintained to the performance identical with that before occurrence of damage by supplying the repairing agent from the outside or the inside and by an appropriate repairing treatment.

In particular, for the resin material portion such as the protective material of the coils 300, improvement in the durability of the resin material can be expected by the self-repairing function of the material per se. In addition, an effect of promoting repair by the heat due to heat generation of the motor can be expected upon repair and, in the resin material incorporating the polymerization agent-incorporated capsules illustrated in Fig. 2, spontaneous repair for the damaged portions, that is, self-repair is possible at the instance the damages are generated.

### 3-4. Structural material

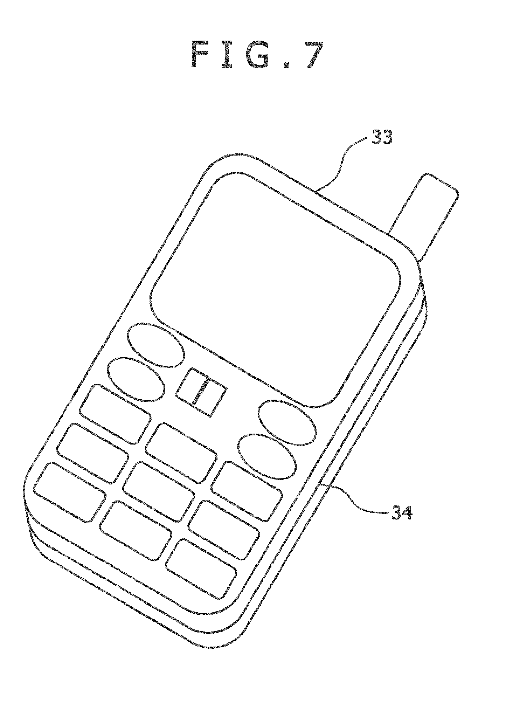

The resin material according to the embodiment is applicable also to structural materials such as casing material, frame material, panel material, and model material. Specific examples of them are to be described with reference to Fig. 7. Fig. 7 is an example of applying the resin material according to the embodiment as a material for a casing 34 constituting a mobile phone 33. The polymerization agent-incorporated capsules illustrated in Fig. 2 are contained in the resin material according to this embodiment used for the casing illustrated in Fig. 7.

In the mobile phone illustrated in Fig. 7, a resin strength and a heat resistance identical with those of the conventional resin materials are maintained. In addition, against damages caused by scratching, deterioration, crackings, etc. during manufacture and use of the casing, the resin strength, and the heat resistance of the damaged portions can be maintained to a performance identical with that before occurrence of damages by supplying the repairing agent from the outside or inside and by an appropriate repairing treatment.

Further, by bonding the structural materials comprising the resin material according to this embodiment just after molding of the materials by using the polymerization agent, seamless bonding can be attained between the structural materials to each other by living radical polymerization.

Further, while an example of the casing is illustrated in Fig. 7, the material to which the resin material according to the embodiment is applicable is not restricted to the casing but the resin material is applicable to parts such as frame material, panel material, and model material constituted by a resin material to a field in which seamless bonding is particularly desired. Example

The present invention is to be described more specifically with reference to examples but the invention is not restricted to the following contents and the invention can be practiced by any modification within a range not impairing the gist of the invention.

### 1. Preparation of resin material

### Example 1 Preparation of resin material using styrene

To 10 g of styrene (manufactured by Tokyo Chemical Industry Co., Ltd., Model No. S0095), 0.3 g of diethylmethoxyborane (manufactured by Aldrich Co., Model No.: 347205) (3 mass% based on styrene) was added and they were stirred and mixed by a stirrer. The obtained mixture was placed in an aluminum cup and the aluminum cup was heated in a baking oven. Heating was performed by bulk polymerization in the baking oven in air at polymerization temperature and polymerization time of 60°C for 30 min, 80°C for 30 min, and 120°C for 60 min in this order. After heating, the mixture was cooled to a room temperature to obtain a resin material (1). The yield of the obtained resin material (1) was 96%.

### Example 2 Preparation of resin material using methyl methacrylate

To 10 g of methyl methacrylate (manufactured by Tokyo Chemical Industry Co., Ltd., Model No. M0087), 0.3 g of diethylmethoxyborane (manufactured by Aldrich Co., Model No.: 347205) (3 mass% based on methyl methacrylate) was added and they were stirred and mixed by a stirrer. The obtained mixture was heated and cooled in the same manner as in Example 1 to obtain a resin material (2). The yield of the obtained resin material (2) was 95%.

### Example 3 Preparation of resin material using vinyl acetate

To 10 g of vinyl acetate (manufactured by Wako Pure Chemical Industries Ltd., Model No. 224-00246), 0.3 g of diethylmethoxyborane (manufactured by Aldrich Co., Model No.: 347205) (3 mass% based on vinyl acetate) was added and they were stirred and mixed by a stirrer. The obtained mixture was heated and cooled in the same manner as in Example 1 to obtain a resin material (3). The yield of the obtained resin material (3) was 94%.

### Example 4 Preparation of resin material using styrene and maleic acid anhydride (copolymer)

To a mixture of 5.2 g (50 mmol) of styrene (manufactured by Tokyo Chemical Industry Co., Ltd., Model No.: S0095) and 4.8 g (50 mmol) of maleic acid anhydride (manufactured by Tokyo Chemical Industry Co., Ltd., Model No.: M0005), 0.3 g of diethylmethoxyborane (manufactured by Aldrich Co. Model No.: 347205) (3 mass% based on the total amount of styrene and maleic acid anhydride) was added, and they were stirred and mixed by a hot stirrer at 55°C. The obtained mixture was heated and cooled in the same manner as in Example 1 to obtain a resin material (4). The yield of the obtained resin material (4) was 95%.

### Example 5 Preparation of resin material using styrene and divinyl benzene (copolymer)

To 2.3 g (22 mmol) of styrene (manufactured by Tokyo Chemical Industry Co., Ltd., Model No.: S0095) and 2.9 g (22 mmol) of divinyl benzene (80% divinyl benzene, manufactured by Aldrich Co. Model No.: 414565), 0.156 g of diethylmethoxyborane (manufactured by Aldrich Co. Model No.: 347205) (3 mass% based on the total amount of styrene and divinyl benzene) was added, and they were stirred and mixed by a stirrer. The obtained mixture was heated and cooled in the same manner as in Example 1 to obtain a resin material (5). The yield of the obtained resin material (5) was 97%.

### Example 6 Preparation of resin material comprising hardened product of unsaturated polyester varnish

To 5.0 g of an unsaturated polyester varnish (manufactured by Hitachi Chemical Co., Ltd., WP2820GN (unsaturated polyester/styrene mixture)), 0.15 g of diethylmethoxyborane (manufactured by Aldrich Co. Model No. 347205) (3 mass% based on unsaturated polyester varnish) was added and they were stirred and mixed by a stirrer. The obtained mixture was heated and cooled in the same manner as in Example 1 to obtain a resin material (6) comprising hardened product of the unsaturated polyester varnish. The yield of the resin material (6) was 98%.

### Comparative Example 1

A resin material (7) was prepared in the same manner as in Example 1 except for using tert-butyl(3,5,5-trimethylhexanoyl)peroxide (manufactured by Hitachi Chemical Co., Ltd., CT-45) instead of diethylmethoxyborane. Tert-butyl(3,5,5-trimethylhexanoyl)peroxide is a peroxide, which is a radical polymerization initiator not causing living radical polymerization. The yield of the obtained resin material (7) was 95%.

### Comparative Example 2

A resin material (8) was prepared in the same manner as in Example 2 except for using tert-butyl(3,5,5-trimethylhexanoyl)peroxide (manufactured by Hitachi Chemical Co., Ltd., CT-45) instead of diethylmethoxyborane. The yield of the obtained resin material (8) was 95%.

### Comparative Example 3

A resin material (9) was prepared in the same manner as in Example 3 except for using tert-butyl(3,5,5-trimethylhexanoyl)peroxide (manufactured by Hitachi Chemical Co., Ltd., CT-45) instead of diethylmethoxyborane. The yield of the obtained resin material (9) was 93%.

### Comparative Example 4

A resin material (10) was prepared in the same manner as in Example 4 except for using tert-butyl(3,5,5-trimethylhexanoyl)peroxide (manufactured by Hitachi Chemical Co., Ltd., CT-45) instead of diethylmethoxyborane. The yield of the obtained resin material (10) was 93%.

### Comparative Example 5

A resin material (11) was prepared in the same manner as in Example 5 except for using tert-butyl(3,5,5-trimethylhexanoyl)peroxide (manufactured by Hitachi Chemical Co., Ltd., CT-45) instead of diethylmethoxyborane. The yield of the obtained resin material (11) was 98%.

### Comparative Example 6

A resin material (12) was prepared in the same manner as in Example 6 except for using tert-butyl(3,5,5-trimethylhexanoyl)peroxide (manufactured by Hitachi Chemical Co., Ltd., CT-45) instead of diethylmethoxyborane. The yield of the obtained resin material (12) was 97%.

### 2. Evaluation of self-repairing function in resin materials (1) to (12)

### 2-1. In the use of polymerization agent identical with unsaturated monomer constituting resin material

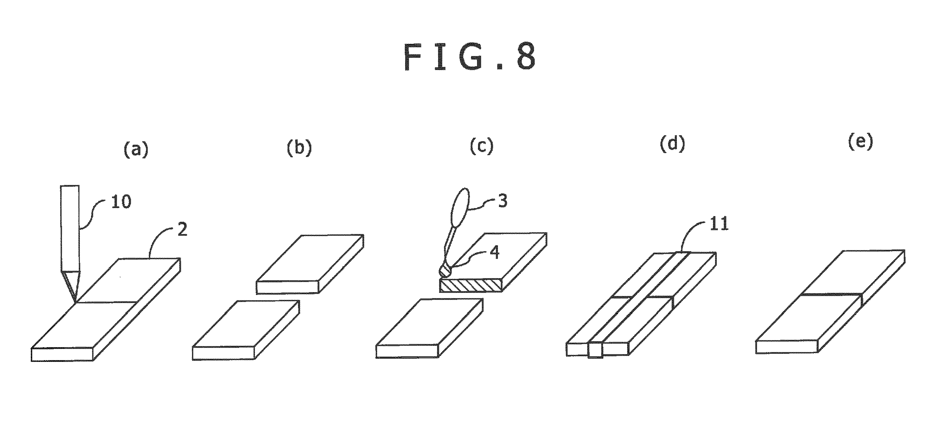

For the resin materials (1) to (12), fracture and repair were applied by the following method and the repairing function of the resin materials was evaluated. Fig. 8 illustrates a re-bonding method of the resin material 2. After each of the obtained resin materials 2 is scratched by a cutter knife 10 (Fig. 8(a)), the resin material 2 was split by holding the resin material 2 at both ends and bending the same (Fig. 8(b)). A polymerization agent 4 comprising an unsaturated monomer constituting the resin material was uniformly coated to fracture surfaces by using a syringe 3 (Fig. 8(c)), the fracture surfaces were brought into close contact to each other and then the resin materials 2 were fixed by a polyimide tape 11 (Fig. 8(d)).

The polymerization agent 4 used in this case did not contain ingredients inducing and promoting polymerization such as peroxide, radical generator, Lewis acid, and polymerization catalyst at all. The fixed resin material 2 was subjected to a repairing treatment by heating in air using a baking oven at 60°C for 30 min, 80°C for 30 min, and 120°C for 30 min in this order to obtain a resin material 2 after bonding (Fig. 8(e)). Then, for the obtained resin material 2, repairing (re-bonding) behavior of the resin material by re-polymerizing reaction was evaluated.

Specifically, the resin material 2 obtained by re-polymerizing reaction was fabricated to 10 mm width, 3 to 5 mm thickness and 30 mm or more length by a low speed cutter to prepare measurement samples which were served for the tensile strength test described below.

The tensile strength test was performed by using a precision universal tester autograph (manufactured by Shimazu Corp. AGS-100G). A resin material including a fracture surface was adjusted for position such that the fracture surface situated at the center of holding arm span and the tensile strength and the tensile elongation (elongation) ratio of the resin were measured under a tensile mode. Conditions were set at a temperature of 25°C, a tensile speed of 1 mm/min, a span of sample held on arms of 10 mm, and a chucking allowance of arm of 10 to 30 mm. Measurement was performed on every 10 samples and an average value thereof was defined as a measured value.

Further, the ratio for the tensile strength of the resin material 2 after re-bonding, to the strength upon fracture before re-bonding being assumed as 100% was defined as a repairing ratio for the tensile strength and the repair function was evaluated. That is, the repairing ratio is a value obtained by dividing the fracture strength after re-bonding by the fracture strength before re-bonding and being multiplied by 100.

Also, the glass transition temperature of the resin material was measured. Measurement was performed by using a thermo-mechanical property analyzer (TMA: manufactured by ULVAC Co., thermo-mechanical analyzer (TM-9300)). Measurement was conducted under the measuring conditions at 5°C/min in a nitrogen atmosphere for each of the cases.

The results are shown in Table 1. Table 1 also shows together the tensile strength, the elongation ratio, and the glass transition temperature of the resin material 2 before fracture.

[Table 1]

**[Table 1. Evaluation result]**

| | Resin material | Tensile strength (MPa) | | Elongation ratio (%) | | Repairing ratio of tensile strength (%) | Glass transition temperature (°C) | | Reduction ratio of glass transition temperature (%) |
|---|---|---|---|---|---|---|---|---|---|
| | | Before repair | After repair | Before repair | After repair | | Before repair | After repair | |
| Example 1 | (1) | 29 | 27 | 0.9 | 0.9 | 93% | 98 | 98 | 0 |
| Example 2 | (2) | 38 | 38 | 4.2 | 4.1 | 100% | 106 | 105 | 0.95 |
| Example 3 | (3) | 13 | 12 | 5.2 | 5 | 92% | 33 | 33 | 0 |
| Example 4 | (4) | 31 | 31 | 2.9 | 2.9 | 100% | 121 | 121 | 0 |
| Example 5 | (5) | 24 | 23 | 3.8 | 3.6 | 96% | 105 | 104 | 0.96 |
| Example 6 | (6) | 25 | 25 | 7.3 | 7.2 | 100% | 111 | 111 | 0 |
| Comp. Example 1 | (7) | 31 | n.d. | 1.1 | n.d. | n.d. | 97 | n.d. | n.d. |
| Comp. Example 2 | (8) | 37 | n.d. | 4.5 | n.d. | n.d. | n.m. | n.d. | n.d. |
| Comp. Example 3 | (9) | 14 | n.d. | 4.9 | n.d. | n.d. | n.m. | n.d. | n.d. |
| Comp. Example 4 | (10) | 27 | n.d. | 2.5 | n.d. | n.d. | n.m. | n.d. | n.d. |
| Comp. Example 5 | (11) | 25 | n.d. | 3.5 | n.d. | n.d. | 107 | n.d. | n.d. |
| Comp. Example 6 | (12) | 28 | n.d. | 7.7 | n.d. | n.d. | 109 | n.d. | n.d. |

| | | | | | | | | | |
|---|---|---|---|---|---|---|---|---|---|
| *: In Table 1, "n.d." means that measurement was impossible, and "n.m." means that measurement was not performed. | | | | | | | | | |

As shown in Table 1, for the resin materials (1) to (6) obtained by performing living radical polymerization (Examples 1 to 6), high repairing ratio (that is, low reduction ratio) for the tensile strength and low reduction ratio for the glass transition temperature were obtained in each of them. Specifically, the reduction ratio of the tensile strength (= 100 - repairing ratio) was within 10% and the reduction ratio of the glass transition temperature was also within 10% in each of them. The result is attributable to that radical polymerization ends having living radical reactivity present at the fracture surface were re-polymerized with the unsaturated monomer in the polymerization agent by the coating of the polymerization agent.

Further, when the end faces of the resin materials (1) to (6) after repair were observed, the resin material destroyed at the repaired portion showed not interfacial failure but cohesion failure in each of them. Further, after the tensile test, destruction was confirmed at many portions other than the repaired portion. The results are attributable to that since the bonding strength was extremely high at the bonded surface between the resin materials 2 to each other which are separated into two pieces, peeling did not occur at the bonded surface but the resin material per se was destructed by the tensile force. Further, it was also found that there was no difference in the strength between the repaired portions and the portions other than the repaired portions.

Further, the resin materials (1) to (6) obtained in Examples 1 to 6 showed values substantially identical with those before the repair also for the glass transition temperature in the same manner as in the resin strength. Also in view of the result, it has been found that the heat resistance was maintained substantially identical before and after the repair.

This is attributable to that since the radical polymerization ends present at the fracture surface formed by fracture of the resin material and the unsaturated monomer contained in the polymerization agent performed radical polymerization, two fracture surfaces were covalent bonded chemically to each other through the radical polymerization to provide bonding of the resin materials with no microscopic boundary. That is, the two fracture surfaces are bonded to each other by covalent bonds due to repetitive units derived from the unsaturated monomer contained in the polymerization agent.

From the result described above, it has been found that each of the resin materials (1) to (6) formed by living radical polymerization had the self-repairing function.

On the other hand, in the resin materials (7) to (12) obtained by polymerization using a peroxide not exhibiting living radical polymerizability (Comparative Examples 1 to 6), repair did not occur in any of the resin materials and the tensile strength, etc. could not be measured. That is, it has been found that the fractured resin materials were not re-bonded to each other and none of them had self-repairing function. This is considered to be attributable to the following reasons.

That is, the peroxide initiator used generally as the radical polymerization initiator contributes only to the generation of radicals but does not form an intermediate structure (Dormant species) as observed in the alkyl borane initiator. Further, radical growing ends are eliminated by re-combination or disproportionation upon completion of polymerization. Therefore, re-polymerization did not occur in the resin materials (7) to (12) obtained in Comparative Examples 1 to 6.

As other example, the state before and after the repair of the resin material (6) comprising a hardened product of the unsaturated polyester varnish prepared in Example 6 is shown. As illustrated in Fig. 9, also the fractured resin material illustrated in Fig. 9(a) can be repaired integrally as illustrated in Fig. 9(b), quite irrespective of properties such as the kind and the structure of the unsaturated monomer constituting the resin material, and whether the resin is homopolymer or polymer and thermoplastic or thermosetting. It has been also found that the fracture surfaces were supported to each other in the repair by merely fixing the two resin materials each other with a polyimide tape and no strong external force is necessary for repair.

### 2-2. In the use of polymerization agent different from unsaturated monomer constituting resin material

In "2-1. In the use of polymerization agent identical with unsaturated monomer constituting resin material" described above, the unsaturated monomer identical with the unsaturated monomer constituting the resin material was coated on the fracture surface. Next, the self-repairing function when coating the different unsaturated monomer was evaluated.

As the resin material, the resin material (6) prepared in Example 6 was used. The resin material (6) was re-bonded by the same method as illustrated in Fig. 8 except that a polymerization agent containing methyl methacrylate was coated instead of the unsaturated polyester varnish on the fracture surface. Then, the tensile strength, the elongation ratio, and the glass transition temperature were measured for the resin material obtained after re-bonding. As a result, the tensile strength was 25 MPa, the elongation ratio was 7.1%, and the glass transition temperature was 108°C.

It has been found that even when the unsaturated monomer contained in the polymerization agent was different from the unsaturated monomer constituting the resin material, the resin material was repaired (re-bonded) and the resin material exhibited the repairing function. Since the constitution were different from that of the original resin material, the recovery ratio was not shown but the material showed substantially identical performance with that of the unsaturated polyester varnish as the base material.

In particular, as a result of observing the end face after the tensile test, it was found that fracture at the repaired portion was not an interfacial failure but a cohesion failure in any of the cases in the same manner as in the result described in "2-1. In the use of polymerization agent identical with unsaturated monomer constituting resin material". This is attributable to that since the radical polymerization ends derived from the unsaturated polyester varnish present at the fracture surface and methyl methacrylate were radically polymerized, two fracture surfaces were covalent bonded chemically to each other through the radical polymerization to cause bonding of the resin material with no microscopic boundary. That is, the two fracture surfaces were bonded to each other by way of the covalent bond due to repetitive units derived from methyl methacrylate.

Further, in the repair using the unsaturated monomers different between the polymerization agent and the resin material, a chemical bonding structure such as block copolymer was formed by the polymerization of polymerization ends having living radical reactivity present at the fracture surface and the polymerization agent.

Further, also the glass transition temperature exhibited substantially identical value in the same manner as the result of the tensile strength. The result is also attributable to that since radical polymerization ends derived from the unsaturated polyester varnish present at the fracture surface and methyl methacrylate performed radical polymerization, the two fracture surfaces were covalent bonded chemically through the radical polymerization to bond the resin material with no microscopic boundary. That is, the two fracture surfaces were bonded by way of covalent bond due to repetitive units derived from methyl methacrylate.

### 2-3. Bonding of two resin materials without fracture of the resin material

Physical properties of a resin material obtained by coating a polymerization agent to the lateral surface of the obtained resin material (6) and bonding the two resin materials (6) to each other without fracture of the resin material (6) prepared in Example 6 were evaluated.

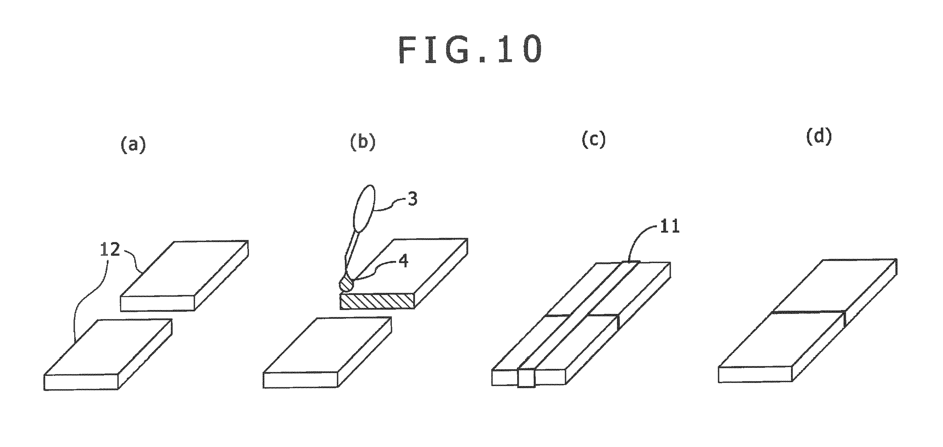

Specifically, as illustrated in Fig. 10(a), two resin materials 12 prepared in Example 6 were provided, and a polymerization agent 4 was coated by using a syringe 3 on the lateral surface of each of the resin materials 12 (Fig. 10(b)). In this case, the polymerization agent 4 contained an unsaturated monomer identical with the unsaturated monomer constituting the resin material 12 (unsaturated polyester varnish). Then, the two resin materials 12, 12 were fixed to each other with a polyimide tape 11 (Fig. 10(c)), to obtain a resin material in which the two resin materials 12, 12 were bonded.

For the obtained resin material, the tensile strength, the elongation ratio, and the glass transition temperature in the resin material after repair were measured in the same method as described in "2-1. In the use of polymerization agent identical with unsaturated monomer constituting resin material". As a result, the tensile strength was 25 MPa, the elongation ratio was 7.3%, and the glass transition temperature was 111°C.

Since a number of Dormant species were present at the surface of the resin material (6) just after the preparation in the same manner as in "2-1. In the use of polymerization agent identical with unsaturated monomer constituting resin material" described above, the resin materials (6) were bonded (adhered) to each other by way of the surface of the resin material through living radical polymerization. As a result, also the tensile strength, the elongation ratio, and the glass transition temperature of the resin material (6) were identical with those of the resin material of Example 6 and the same phenomenon occurred as in the case of applying fracture and re-bonding. In view of such a result, the repairing behavior occurred not only at the fracture surface but also living radical polymerization proceeded being started from the surface of the resin material (6) as the base material.

### 3. Evaluation of self-repairing function due to change of the concentration of radial polymerization initiator.

In Example 6, 0.15 g of diethylmethoxyborane (3 mass% based on unsaturated monomer) was added. Resin materials were prepared in the same manner as in Example 6 except for changing the addition amount of diethylmethoxyborane to 0.005 g (0.1 mass%; Example 7), 0.025 g (0.5 mass%; Example 8), 0.05 g (1 mass%; Example 9), and 0.25 g (5 mass%; Example 10), and obtained resin materials were evaluated in the same manner as described above. Table 2 shows the result of evaluation. Table 2 also shows the result of Example 6 together.

**[Table 2: Evaluation result]**

| | Concentration of polymerization initiator (mass%) | Tensile strength (MPa) | | Elongation ratio (%) | | Repairing ratio of tensile strength (%) |
|---|---|---|---|---|---|---|
| | | Before repair | After repair | Before repair | After repair | |
| Example 7 | 0.1 | 17 | 0.1 | 5.3 | 0 | 0.59 |
| Example 8 | 0.5 | 24 | 8 | 7.3 | 28 | 33 |
| Example 9 | 1 | 25 | 25 | 7.7 | 7.2 | 100 |
| Example 6 | 3 | 25 | 25 | 7.3 | 7.2 | 100 |
| Example 10 | 5 | 25 | 25 | 7.0 | 7.2 | 100 |

As shown in Table 2, in the resin materials before repair, the tensile strength and the elongation ratio increased along with increase in the concentration of diethylmethoxyborane (polymerization initiator). This is attributable to the increase of the crosslinking density of the unsaturated polyester varnish by the increase in the concentration of the polymerization initiator. Further, while re-bonding occurred in the resin material at the concentration of the polymerization initiator of 0.1 mass% for the resin material after repair, the repairing ratio was extremely low. This is considered to be attributable to the insufficiency of the Dormant species for recombination in the inside of the resin material.

In the resin materials at the concentration of the polymerization initiator of 0.1 mass% to 1 mass%, the tensile strength, the elongation ratio, and the repairing ratio of the tensile strength after repair increased and, in the resin material at a concentration of the polymerization initiator of 1 mass% or more, 100% of repairing ratio is shown. This is attributable to that sufficient Dormant species were formed when the concentration of the polymerization initiator was 1 mass% or more to show high repair function. In particular, in the resin materials at the concentration of the polymerization initiator of 1 mass% or more, a number of resin materials destroyed were confirmed at the portions other than the repaired portion after the tensile test and there is scarce difference of the strength between the repaired portions and other portions than the repaired portions.

In view of the result described above, it has been found that in the resin material at the concentration of the polymerization initiator of 0.1 mass% or more, the self-repairing function was shown and, particularly, in the resin material at the concentration of the polymerization initiator of 1 mass% or more, the resin strength was recovered to a level identical with that before repair.

### 4. Evaluation on self-repairing function for resin material containing polymerization agent-incorporated capsule

### 4-1. Preparation of polymerization-incorporated capsule

Capsules incorporating the unsaturated polyester varnish as the unsaturated monomer (polymerization agent-incorporated capsules) were prepared by the method shown below. First, an organic phase solution and an aqueous phase solution of the compositions shown below were prepared.

### • Organic phase solution

Dichloromethane (manufactured by Wako Pure Chemical Industries Ltd., Model No. 135-02446) 20 g
Polymethyl methacrylate (manufactured by Aldrich Co. Molecular weight MW = 15,000 Model No. 200336) 2 g
Unsaturated polyester varnish (manufactured by Hitachi Chemical Co., Ltd., WP2820GN) 8 g
Sorbitane monooleate (manufactured by Tokyo Chemical Industry Co., Ltd., Span 80 Model No. S0060) 0.6 g
Isooctane (manufactured by Wako Pure Chemical Industries Ltd., Model No. 202-02886) 1g

### • Aqueous phase solution

Water 200 g
Polyvinyl alcohol (manufactured by Wako Pure Chemical Industries Ltd., polymerization degree 1000, Model No. 162-16325) 2 g
Aqueous solution of calcium tertiary phosphate (manufactured by Taihei Chemical Industrial Co., Ltd. TCP-10U) 100 g

The organic phase solution and the aqueous phase solution were mixed at 2,000 rpm for 10 min to prepare an O/W emulsion. The obtained emulsion was transferred to an egg plant flask, depressurized to about 30 kPa, and dried in a solution at 250 rpm and at a solution temperature of 35°C for 8 hours. During drying, a heat treatment is applied so as to gradually remove dichloromethane and isooctane as the organic solvent from the inside of the oil droplets contained in the emulsion.

Then, oil droplets after solvent evaporation were separated by filtration, washed with an aqueous solution of 0.5 M hydrochloric acid to remove deposits such as calcium tertiary phosphate, and then freeze-dried to obtain polymerization agent-incorporated capsules. The yield was 74%.

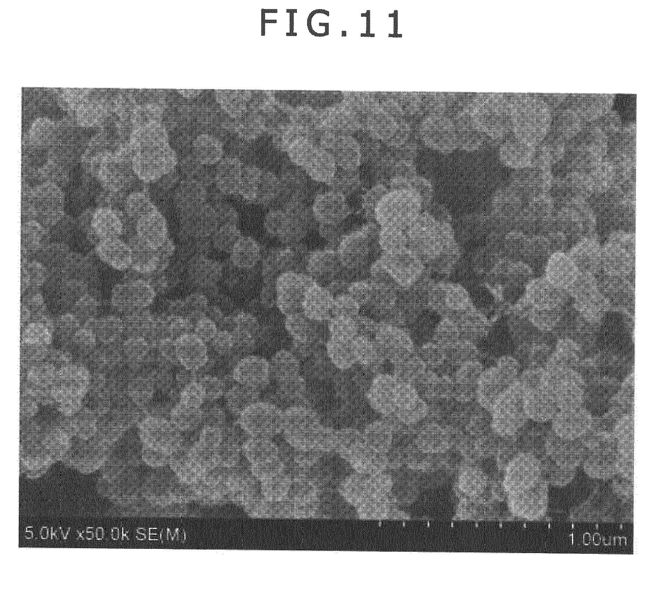

Fig. 11 shows an SEM photograph taken for the obtained polymerization agent-incorporated capsules by a scanning electron microscope (manufactured by Hitachi High Technologies Corp., Model No.: S-4800). As illustrated in Fig. 11, it has been found that the polymerization agent-incorporated capsules had a fine structure and could supply the unsaturated monomer as the polymerization agent in a self-repairing manner and at a high efficiency to damaged portions by compositing (dispersing) them into the resin material.

Based on the SEM photograph shown in Fig. 11, the average particle diameter of the polymerization agent-incorporated capsules was measured. As a result, it was found that the average particle diameter of the polymerization agent-incorporated capsules was 1.6 µm.

Further, the amount of the polymerization agent incorporated in the polymerization agent-incorporated capsule was determined by artificially crushing the polymerization agent-incorporated capsule to remove the polymerization solution in the capsule and then drying the capsule cell and measuring the change of the mass of the capsule. As a result, it has been found that the content of the unsaturated polyester varnish contained in the polymerization agent-incorporated capsule was 41.8 mass% based on the entire amount of the polymerization agent-incorporated capsule before the treatment.

### 4-2. Preparation of resin material containing polymerization agent-incorporated capsule (Example 11)

A resin material containing polymerization agent-incorporated capsules was prepared by the following method using the polymerization agent-incorporated capsules prepared as described above.

5.0 g of an unsaturated polyester varnish (manufactured by Hitachi Chemical Co., Ltd., WP2820GN (unsaturated polyester/styrene mixture)) and 0.15 g of diethylmethoxyborane (manufactured By Aldrich Co., Model No.: 347205) were mixed and stirred by a stirrer. 1 g of the polymerization agent-incorporated capsules prepared as described above was further added to the mixture after stirring and then stirred again by the stirrer.

After stirring, the obtained mixture was placed in an aluminum cup, and the aluminum cup was heated in a baking oven to prepare a resin material containing polymerization agent-incorporated capsules (Example 11). The heating conditions were identical with those of Example 6. The yield in this case was 96%. When a tensile strength and an elongation ratio were measured by the same method as in Example 6 using the obtained resin material, the tensile strength was 22 MPa and the elongation ratio was 7.1%.

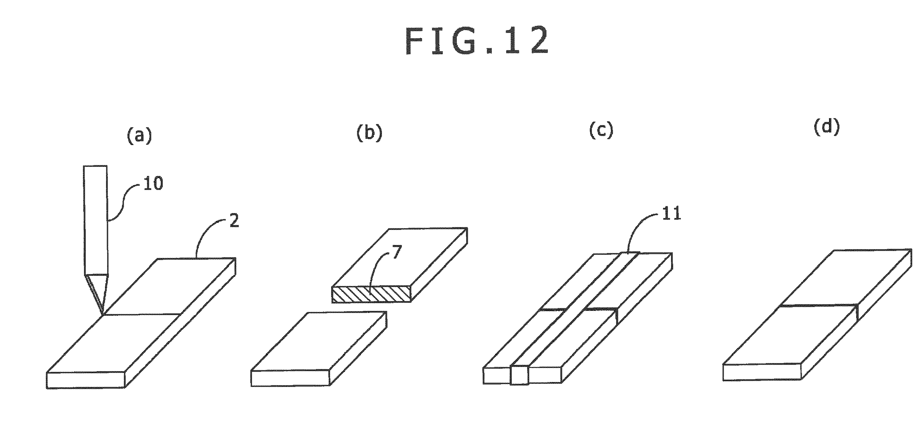

Since the obtained resin material had a configuration in which the polymerization agent can be supplied to a resin material upon fracture, this is a material capable of autonomously repairing cracks in the resin material (self-repairing material). Accordingly, supply of the polymerization agent from the outside is not necessary and uniform repair can be performed easily. Accordingly, with the view point described above, the obtained resin material was fractured by the method shown below and re-bonded by the method illustrated in Fig. 12 in order to evaluate the self-repairing function.

After the obtained resin material 2 is slitted by a cutter knife 10 (Fig. 12(a)), the resin material was bent by holding both ends thereof to split the resin material (Fig. 12(b)). Then, after the fracture surfaces 7 are instantly brought into close contact to each other, the resin material was fixed by a polyimide tape 11 (Fig. 12(c)). The fixed resin material was put to a repairing treatment by heating in air at 60°C for 30 min, 80°C for 30 min, and then 120°C for 30 min in this order by using a baking oven to obtain a re-bonded resin material (Fig. 12(d)). Then, the repairing (re-bonding) behavior of the obtained resin material was evaluated. Specifically, a tensile strength, an elongation ratio, a repairing ratio of the tensile strength, a glass transition temperature, and a reduction ratio of the glass transition temperature were measured for the obtained resin material in the same manner as in Example 6. Table 3 shows the result. Table 3 also ) shows the result of Example 6 in which the polymerization agent-incorporated capsules were not dispersed.

[Table 3]

**[Table 3. Evaluation result]**

| | Tensile strength (MPa) | | Elongation ratio (%) | | Repairing ratio of tensile strength (%) | Glass transition temperature (°C) | | Reduction ratio of glass transition temperature (%) |
|---|---|---|---|---|---|---|---|---|
| | Before repair | After repair | Before repair | After repair | | Before repair | After repair | |
| Example 6 | 25 | 25 | 7.3 | 7.2 | 100% | 111 | 111 | 0 |
| Example 11 | 22 | 22 | 7.1 | 6.9 | 100% | 108 | 108 | 0 |

In the resin material of Example 11, the tensile strength of the resin material after repair was identical with that before repair and the repairing ratio was 100% in ) the same manner as in the resin material of Example 6. Further, the material showed identical value also for the glass transition temperature in the same manner as the result for the tensile strength, and the reduction ratio of the glass transition temperature was 0%. The results are attributable to that the radical polymerization ends present at the fracture surface and the leaked unsaturated monomer performed radical polymerization and two fracture surfaces were covalent bonded chemically through the radical polymerization to cause bonding of the resin material with no microscopic boundary. That is, the two fracture surfaces were bonded to each other by way of covalent bonds due to repetitive units derived from the unsaturated monomer contained in the polymerization agent.

Since the resin material of Example 11 had a structure containing the polymerization agent-incorporated capsules, it had a feature not requiring external supply of the polymerization agent. Therefore, according to the resin material in which the polymerization agent-incorporated capsules were dispersed, resin material could be repaired more easily. Further, also in a case where the polymerization agent-incorporated capsules were dispersed in the resin material, the material showed a tensile strength, an elongation ratio, and a glass transition temperature comparable with those of the resin material with no dispersion of the capsules. In view of the above, the strength of the resin material was not deteriorated by the dispersion of the polymerization agent-incorporated capsules.

In view of the result described above, a resin material provided with the self-repairing performance and capable of efficiently and easily repairing the material can be obtained by the structure in which the polymerization agent-incorporated capsules are dispersed as in the resin material of Example 11.

### Description of Reference Symbols

- 1: Crack
- 1a: Fracture surface
- 2: Resin material
- 3: Syringe
- 4: Polymerization agent
- 5: Resin repairing film
- 6: Polymerization agent-incorporated capsule
- 7: Bonded layer
- 10: Cutter knife
- 11: Polyimide tape
- 12: Resin material
- 13: Conductor
- 14: Internal semiconductor layer
- 15: Insulation layer
- 16: External semiconductor layer (adhesion layer)
- 17: External semiconductor layer (separation layer)
- 18: Coating layer
- 19: Outer skin layer
- 20: Coating layer
- 21: Insulation layer
- 22: Lead frame
- 23: Mold sealant
- 25: Bonding wire
- 24: Semiconductor device
- 24a: Substrate
- 26: Core
- 27: Coated copper wire
- 28: Motor coil protective material
- 29: Stator coil
- 30: Stator core
- 31: Slot
- 32: Rotor core
- 33: Mobile phone
- 34: Casing
- 200: DIP
- 300: Motor coil protective material
- 301: Motor

## Claims

1. A resin material containing a resin formed by living radical polymerization of an unsaturated monomer polymerizable by a radical polymerization initiator, wherein
upon fracture of the resin material, the resin material has a self-repairing function in which, when sites capable of initiating radical polymerization are present at a fracture surface formed by the fracture and an unsaturated monomer capable of radical polymerization with the sites is brought into contact with the sites, radical polymerization of the unsaturated monomer to the sites is performed.

2. The resin material according to claim 1, comprising
vessels to encapsulate an unsaturated monomer capable of polymerization to the sites present at the fracture surface and capable of initiating radical polymerization,
wherein the self-repairing function is provided such that when the vessels are destroyed upon fracture, the incorporated unsaturated monomer leaks out, and the leaked unsaturated monomer is brought into contact with the fracture surface, the unsaturated monomer in contact with the sites capable of initiating radical polymerization is subjected to radical polymerization.

3. The resin material according to claim 1 or 2, wherein
the radical polymerization initiator is an alkyl borane.

4. The resin material according to claim 1 or 2, wherein
the unsaturated monomer is one or more unsaturated monomers selected from the group consisting of aromatic vinyl compounds, alkyl (meth)acrylates, unsaturated monocarboxylic acid esters, fluoroalkyl (meth)acrylates, siloxanyl compounds, mono- or di-(meth)acrylates of alkylene glycols, alkoxyalkyl (meth)acrylates, cyanoalkyl (meth)acrylates, cyano compounds, oligo (meth)acrylates of polyhydric alcohols, hydroxyalkyl (meth)acrylates, hydroxyalkyl esters of unsaturated carboxylic acids, unsaturated alcohols, unsaturated (mono)carboxylic acids, unsaturated polycarboxylic acids or unsaturated polycarboxylic acid anhydrides, mono- or diesters of unsaturated polycarboxylic acids or unsaturated polycarboxylic acid anhydrides, epoxy group-containing unsaturated compounds, diene compounds, vinyl chloride, vinyl acetate, sodium isoprene sulfonate, cinnamic acid esters, crotonic acid esters, dicyclopentadiene, and ethylidene norbornene.

5. The resin material according to claim 1 or 2, wherein
the unsaturated monomer in contact with the sites is an unsaturated monomer which is identical with or different from the unsaturated monomer constituting the resin.

6. The resin material according to claim 2, wherein
the vessel has a particle shape, and
the average particle diameter of the vessel is 10 nm or more and 1 mm or less.

7. A method of manufacturing the resin material according to claim 2, comprising:
a step of mixing the radical polymerization initiator, the unsaturated monomer constituting the resin, and the vessels to encapsulate the unsaturated monomer, and
a step of performing living radical polymerization of the unsaturated monomer constituting the resin.

8. A method of repairing the resin material according to claim 1, wherein
the contact is performed by coating, injecting, dipping, spraying, printing, transferring, or bonding the unsaturated monomer capable of radical polymerization with the sites present at the fracture surface and capable of initiating radical polymerization.

9. A method of repairing the resin material according to claim 2, wherein
the vessel is burst upon fracture of the resin material, and the unsaturated monomer leaks out, and
the leaked unsaturated monomer is brought into contact with the fracture surface, and thereby radical polymerization with the sites capable of initiating the radical polymerization is performed.

10. The method of repairing the resin material according to claim 8 or 9, wherein
the fracture surface is formed by damage, deformation, breakage, scratching, destruction, tearing, cutting, disconnection, deterioration, decomposition, molding, or film formation of the resin material.

11. The method of repairing the resin material according to claim 8 or 9, wherein
a reduction ratio of the strength of the resin material after repair is within 10% of the strength of the resin material before repair.

12. The method of repairing the resin material according to claim 8 or 9, wherein
a reduction ratio of a glass transition temperature of the resin material after repair measured by thermo-mechanical property analysis is within 10% of the glass transition temperature of the resin material before repair measured by thermo-mechanical property analysis.

13. A cable coating material having the resin material according to any one of claims 1 to 6.

14. A cable having the cable coating material according to claim 13.

15. A mold sealant having the resin material according to any one of claims 1 to 6.

16. A mold sealing method using the mold sealant according to claim 15.

17. A potting material for manufacturing a mold sealant, which is used for manufacturing the mold sealant according to claim 15.

18. A package for electronic parts having the mold sealant according to claim 15.

19. A motor coil protective material having the resin material according to any one of claims 1 to 6.

20. A varnish material for a motor coil protective material which is used for manufacturing the motor coil protective material according to claim 19.

21. A motor having the motor coil protective material according to claim 19.

22. A structural material having the resin material according to any one of claims 1 to 6.

23. The structural material according to claim 22, which is a casing material, a frame material, a panel material, or a model material.
